# EUROPEAN PATENT APPLICATION

(11) **EP 4 773 750 A1**
(43) Date of publication of application: **08.07.2026**
(21) Application number: 25226420.5
(22) Date of filing: 22.12.2025
(51) Int. Cl.: H10B 12/00

(54) **SEMICONDUCTOR DEVICES AND METHODS OF MANUFACTURING THE SAME**

(30) Priority: 03.01.2025 KR 20250000634
(71) Applicant: Samsung Electronics Co., Ltd., Suwon-si, Gyeonggi-do 16677 (KR)
(72) Inventor: KANG, Jongin, 16677 Suwon-si, Gyeonggi-do (KR); YOON, Chansic, 16677 Suwon-si, Gyeonggi-do (KR); LEE, Jieun, 16677 Suwon-si, Gyeonggi-do (KR)
(74) Representative: Kuhnen & Wacker Patent- und Rechtsanwaltsbüro PartG mbB

(57) **Abstract**

A semiconductor device includes first, second, and third bitlines (BL1, BL2, BL3) in a memory cell array region (MCA) and an extension region (EXTa). Each of the first, second, and third bitlines (BL1, BL2, BL3) includes a line portion (LP), a connection portion (CP), a pad portion (PP), and an extension portion (EP). The line portions (LPa, LPc) of the first and second bitlines (BL1, BL2) are in the memory cell array region (MCA) and the extension region (EXTa). The connection portions (CPa, CPc), the pad portions (PPa, PPc), and the extension portions (EPa, EPC) of the first and second bitlines (BL1, BL2) are in the extension region (EXTa). An end portion of the line portion (LPb) of the third bitline (BL3) is between the extension portions (EPa, EPc) of the first and second bitlines (BL1, BL2). Widths of the extension portions (EPa, EPc) of the first and second bitlines (BL1, BL2) decrease from the pad portions (PPa, PPc) of the first and second bitlines (BL1, BL2). The end portion of the line portion (LPb) of the third bitline (BL3) has a convex shape.

## Description

### BACKGROUND OF THE INVENTION

Example embodiments of the present disclosure relate to a semiconductor device and a method of manufacturing the same.

Research into reducing a size of elements included in a semiconductor device and improving performance thereof may be performed. For example, in a DRAM, research to reliably and stably form elements having a reduced size may be performed.

### SUMMARY OF THE INVENTION

Example embodiments of the present disclosure may provide semiconductor devices having improved reliability and methods of manufacturing the same.

According to an example embodiment of the present disclosure, a semiconductor device includes a substrate that includes a memory cell array region and a first extension region that is adjacent to the memory cell array region; a first bitline that includes a first line portion that intersects the memory cell array region in a first direction from the memory cell array region toward the first extension region and extends into the first extension region, a first connection portion that extends from the first line portion within the first extension region, a first pad portion that extends from the first connection portion within the first extension region, and a first extension portion that extends from the first pad portion within the first extension region; a second bitline that includes a second line portion that intersects the memory cell array region in the first direction and extends in the first extension region, a second connection portion that extends from the second line portion within the first extension region, a second pad portion that extends from the second connection portion within the first extension region, and a second extension portion that extends from the second pad portion within the first extension region; and a third bitline in the memory cell array region and the first extension region, wherein the third bitline includes a third line portion that has an end portion between the first extension portion and the second extension portion in a second direction that is perpendicular to the first direction, wherein a width in the second direction of the first extension portion decreases from the first pad portion in the first direction, wherein a width in the second direction of the second extension portion decreases from the second pad portion in the first direction, and wherein the end portion of the third line portion of the third bitline has a convex shape in the first direction.

According to an example embodiment of the present disclosure, a semiconductor device includes a substrate that includes a memory cell array region and first and second extension regions that have the memory cell array region therebetween in a first direction; a first bitline that includes a first line portion that intersects the memory cell array region in the first direction from the memory cell array region toward the first extension region and extends into the first extension region, a first connection portion that extends from the first line portion within the first extension region, and a first pad portion that extends from the first connection portion within the first extension region; a second bitline that includes a second line portion that intersects the memory cell array region in the first direction and extends into the first extension region, a second connection portion that extends from the second line portion within the first extension region, and a second pad portion that extends from the second connection portion within the first extension region; a third bitline between the first bitline and the second bitline in a second direction that is perpendicular to the first direction, wherein the third bitline includes a third line portion that intersects the memory cell array region in the first direction from the memory cell array region toward the second extension region and extends into the second extension region, a third connection portion that extends from the third line portion within the second extension region, and a third pad portion that extends from the third connection portion within the second extension region; and a fourth bitline on an opposite side of the third bitline with respect to the second bitline in the second direction, wherein the fourth bitline includes a fourth line portion that intersects the memory cell array region in the first direction and extends into the second extension region, a fourth connection portion that extends from the fourth line portion within the second extension region, and a fourth pad portion that extends from the fourth connection portion within the second extension region, wherein a length of the second line portion is greater than a length of the first line portion in the first direction, and wherein a length of the third line portion is greater than a length of the fourth line portion in the first direction.

According to an example embodiment of the present disclosure, a semiconductor device includes a substrate that includes a memory cell array region and first and second extension regions that have the memory cell array region therebetween in a first direction; and at least one first bitline group on the substrate, wherein the at least one first bitline group includes: a first bitline that includes a first line portion that intersects the memory cell array region in the first direction from the memory cell array region toward the first extension region and extends into the first extension region, a first connection portion that extends from the first line portion within the first extension region, a first pad portion that extends from the first connection portion within the first extension region, and a first extension portion that extends from the first pad portion within the first extension region; a second bitline that includes a second line portion that intersects the memory cell array region in the first direction and extends into the first extension region, a second connection portion that extends from the second line portion within the first extension region, a second pad portion that extends from the second connection portion within the first extension region, and a second extension portion that extends from the second pad portion within the first extension region; a third bitline between the first bitline and the second bitline in a second direction that is perpendicular to the first direction, wherein the third bitline includes a third line portion that intersects the memory cell array region in the first direction from the memory cell array region toward the second extension region and extends into the second extension region, a third connection portion that extends from the third line portion within the second extension region, a third pad portion that extends from the third connection portion within the second extension region, and a third extension portion that extends from the third pad portion within the second extension region; and a fourth bitline on an opposite side of the third bitline with respect to the second bitline in the second direction, wherein the fourth bitline includes a fourth line portion that intersects the memory cell array region in the first direction and extends into the second extension region, a fourth connection portion that extends from the fourth line portion within the second extension region, a fourth pad portion that extends from the third connection portion within the second extension region, and a fourth extension portion that extends from the fourth pad portion within the second extension region, wherein a width in the second direction of each of the first and second extension portions decreases in the first direction, and wherein a width in the second direction of each of the third and fourth extension portions decreases in a third direction that is perpendicular to the first direction and the second direction.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a plan diagram illustrating a semiconductor device according to an example embodiment of the present disclosure;
FIG. 2 is an enlarged diagram illustrating region 'A' illustrated in FIG. 1;
FIG. 3A is an enlarged diagram illustrating region 'B' illustrated in FIG. 2;
FIG. 3B is an enlarged diagram illustrating region 'C' illustrated in FIG. 2;
FIG. 4A is a cross-sectional diagram illustrating regions taken along lines I-I' and II-II' in FIG. 3A;
FIG. 4B is a cross-sectional diagram illustrating a region taken along line III-III' in FIG. 3A;
FIG. 4C is a cross-sectional diagram illustrating a region taken along line IV-IV' in FIG. 3A;
FIG. 4D is a cross-sectional diagram illustrating a region taken along line V-V' in FIG. 3B;
FIG. 4E is a cross-sectional diagram illustrating a region taken along line VI-VI' in FIG. 3B;
FIG. 5A is a plan diagram illustrating a semiconductor device according to an example embodiment of the present disclosure;
FIG. 5B is an enlarged diagram illustrating region 'D' illustrated in FIG. 5A;
FIG. 6A is a plan diagram illustrating a semiconductor device according to an example embodiment of the present disclosure;
FIG. 6B is an enlarged diagram illustrating region 'E' illustrated in FIG. 6A;
FIG. 7A is a plan diagram illustrating a semiconductor device according to an example of the present disclosure;
FIG. 7B is a cross-sectional diagram illustrating a region taken along line II-II' in FIG. 3A;
FIG. 8A is a plan diagram illustrating a semiconductor device according to an example of the present disclosure;
FIG. 8B is a cross-sectional diagram illustrating regions taken along line I-I' in FIG. 8A;
FIG. 9 is a plan diagram illustrating a semiconductor device according to an example of the present disclosure;
FIGS. 10A, 10B, 12A, 12B, 14A, 14B, 16A, 16B, 18A and 18B are plan diagrams illustrating a method of manufacturing a semiconductor device according to an example of the present disclosure; and
FIGS. 11A to 11E, 13A to 13E, 15A to 15E, 17A to 17E, and 19A to 19E are cross-sectional diagrams illustrating a method of manufacturing a semiconductor device according to an example of the present disclosure.

### DETAILED DESCRIPTION

Hereinafter, embodiments of the present disclosure will be described as follows with reference to the accompanying drawings.

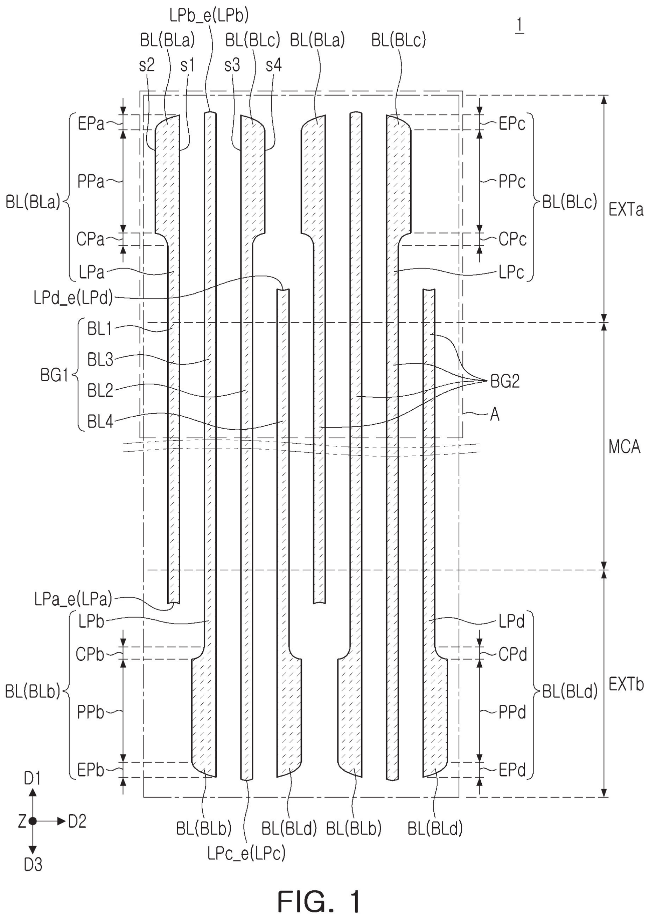

FIG. 1 is a plan diagram illustrating a semiconductor device according to an example embodiment of the present disclosure.

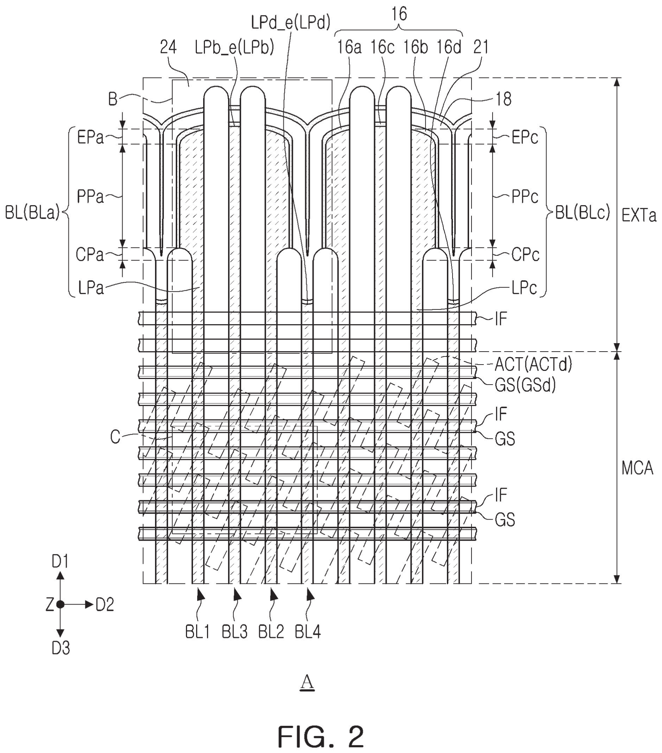

FIG. 2 is an enlarged diagram illustrating region 'A' illustrated in FIG. 1.

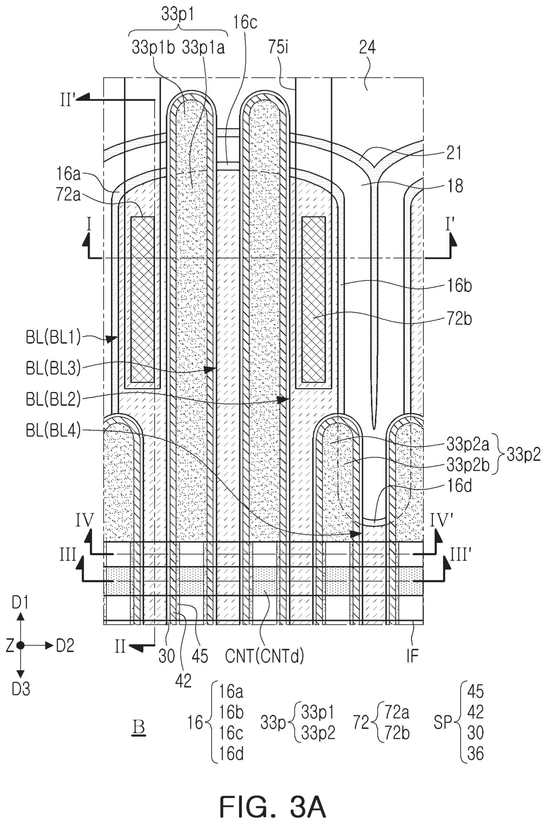

FIG. 3A is an enlarged diagram illustrating region 'B' illustrated in FIG. 2.

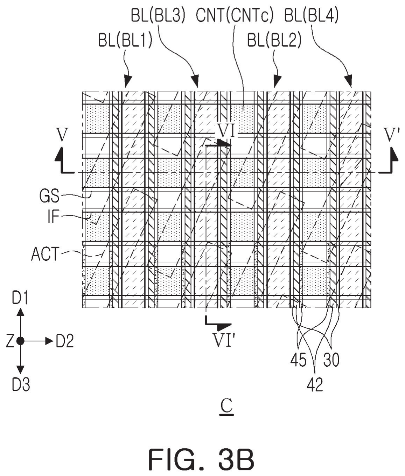

FIG. 3B is an enlarged diagram illustrating region 'C' illustrated in FIG. 2.

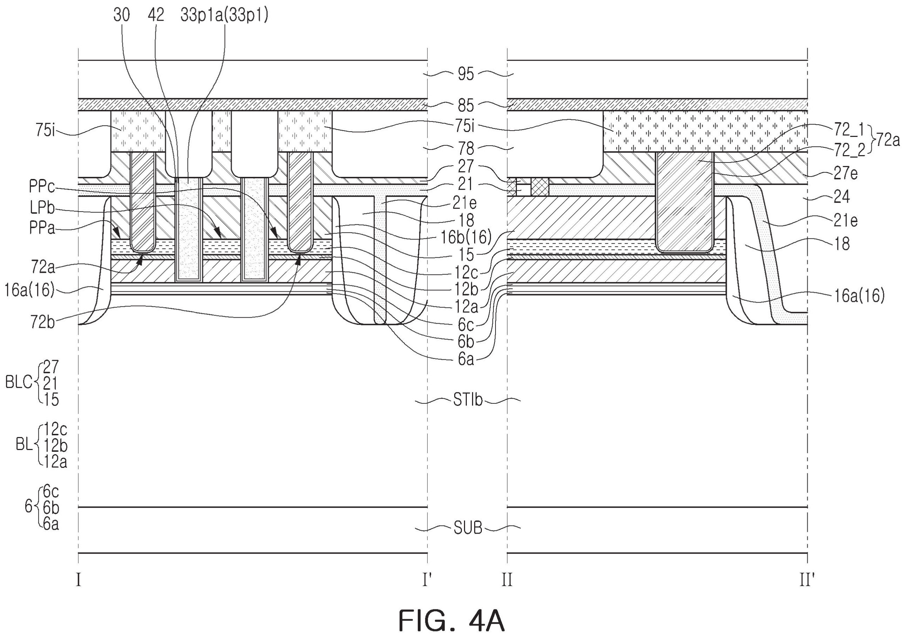

FIG. 4A is a cross-sectional diagram illustrating regions taken along lines I-I' and II-II' in FIG. 3A.

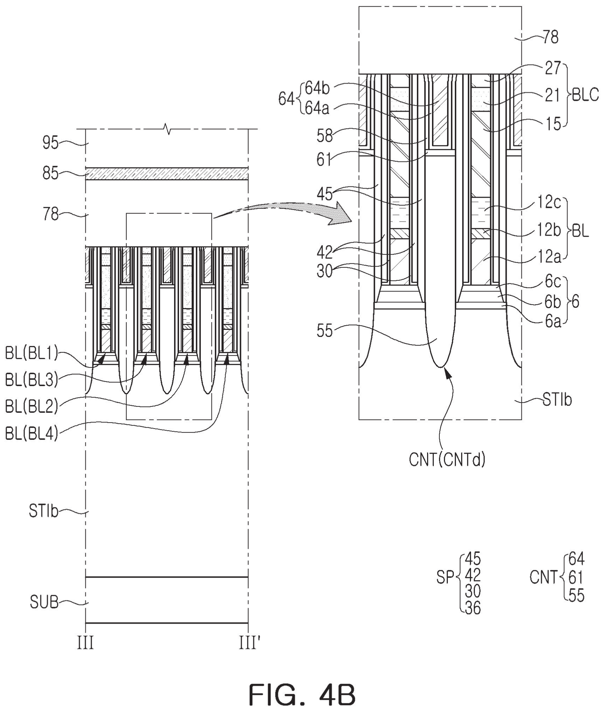

FIG. 4B is a cross-sectional diagram illustrating a region taken along line III-III' in FIG. 3A.

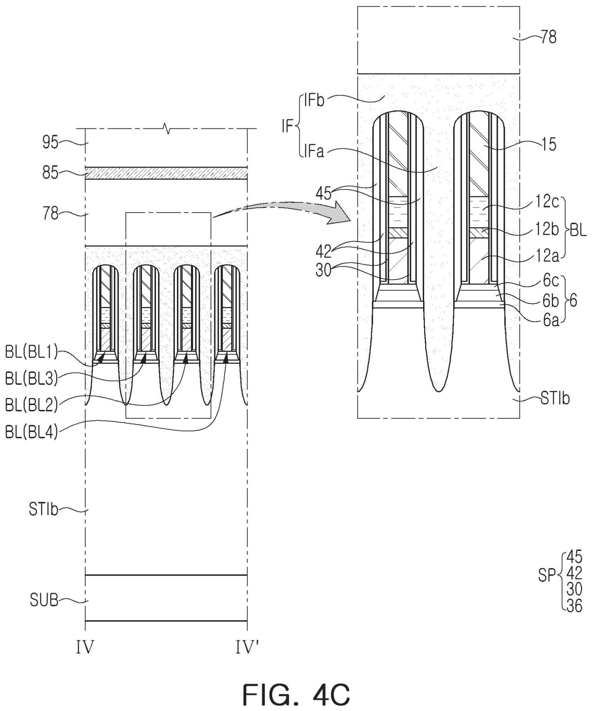

FIG. 4C is a cross-sectional diagram illustrating a region taken along line IV-IV' in FIG. 3A.

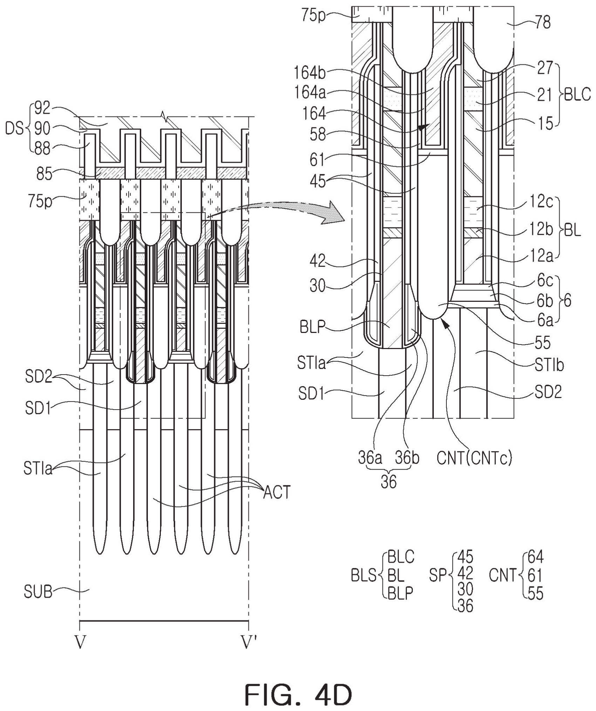

FIG. 4D is a cross-sectional diagram illustrating a region taken along line V-V' in FIG. 3B.

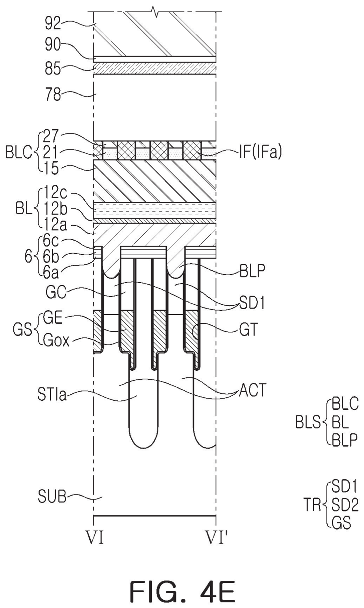

FIG. 4E is a cross-sectional diagram illustrating a region taken along line VI-VI' in FIG. 3B.

Referring to FIGS. 1, 2, 3A, 3B, 4A, 4B, 4C, 4D, and 4E, a semiconductor device 1 according to an example embodiment may include a substrate SUB including a memory cell array region MCA, a first extension region EXTa and a second extension region EXTb.

The substrate SUB may comprise (e.g., may be configured as) a semiconductor device substrate. The substrate SUB may be provided as, for example, a bulk wafer, an epitaxial layer, a silicon on insulator (SOI) layer, or a semiconductor on insulator (SeOl) layer. The substrate SUB may include a group IV semiconductor, a group III-V compound semiconductor, and/or a group II-VI compound semiconductor. For example, the substrate SUB may be a substrate including silicon, silicon carbide, germanium, and/or silicon-germanium. For example, the substrate SUB may be configured as a single crystal silicon substrate including a silicon material, for example, a single crystal silicon material. As used herein, the term "and/or" includes any and all combinations of one or more of the associated listed items.

In an example embodiment, the first, second, and third directions D1, D2, and D3 may be parallel to an upper surface of the substrate SUB, and the vertical direction Z may be perpendicular to the upper surface of the substrate SUB. The first and third directions D1 and D3 may be disposed in opposite directions. The second direction D2 may be perpendicular to the first and third directions D1 and D3.

Memory cells for storing data may be arranged in the memory cell array region MCA. The memory cell array region MCA may be disposed between the first extension region EXTa and the second extension region EXTb. The first extension region EXTa and the second extension region EXTb may be adjacent to the memory cell array region MCA. For example, the first extension region EXTa and the second extension region EXTb may oppose each other with the memory cell array region MCA as a center and adjacent to the memory cell array region MCA. For example, the first extension region EXTa and the second extension region EXTb may have the memory cell array region MCA therebetween in the first direction D1 (in the third direction D3).

The semiconductor device 1 may further include bitlines BL.

The bitlines BL may be arranged in a horizontal direction (e.g., may be spaced apart from each other in D2).

The bitlines BL, arranged in a horizontal direction (e.g., spaced apart from each other in D2), may be configured to include 4n+1st bitlines BLa, 4n+2nd bitlines BLb, 4n+3rd bitlines BLc, and 4n+4th bitlines BLd. Here, the index n may be a natural number including 0 (zero).

Each of the 4n+1st bitlines BLa may be referred to as a first bitline BL1.

Each of the 4n+3rd bitlines BLc may be referred to as a second bitline BL2.

Each of the 4n+2nd bitlines BLb may be referred to as a third bitline BL3.

Each of the 4n+4th bitlines BLd may be referred to as a fourth bitline BL4.

The first bitline BL1 may include a first line portion LPa (at least partially) intersecting (crossing) the memory cell array region MCA in a first direction D1 from the memory cell array region MCA (or from the second extension region EXTb) toward the first extension region EXTa extending into the first extension region EXTa, a first connection portion CPa extending from the first line portion LPa within the first extension region EXTa, a first pad portion PPa extending from the first connection portion CPa within the first extension region EXTa, and a first extension portion EPa extending from the first pad portion PPa within the first extension region EXTa.

The second bitline BL2 may include a second line portion LPc (at least partially) intersecting (crossing) the memory cell array region MCA in a first direction D1 from the memory cell array region MCA (or from the second extension region EXTb) toward the first extension region EXTa and extending into the first extension region EXTa, a second connection portion CPc extending from the second line portion LPc within the first extension region EXTa, a second pad portion PPc extending from the second connection portion CPc within the first extension region EXTa, and a second extension portion EPc extending from the second pad portion PPc within the first extension region EXTa.

A third bitline BL3 may be disposed between the first and second bitlines BL1 and BL2 (in the second direction D2). The third bitline BL3 may include a third line portion LPb (at least partially) intersecting (crossing) the memory cell array region MCA in a third direction D3 from the memory cell array region MCA (or from the first extension region EXTa) toward the second extension region EXTb and extending into the second extension region EXTb, a third connection portion CPb extending from the third line portion LPb within the second extension region EXTb, a third pad portion PPb extending from the third connection portion CPb within the second extension region EXTb, and a third extension portion EPb extending from the third pad portion PPb within the second extension region EXTb.

A fourth bitline BL4 may be disposed on an opposite side of the third bitline BL3 with respect to the second bitline BL2 (in the second direction D2). The fourth bitline BL4 may include a fourth line portion LPd (at least partially) intersecting (crossing) the memory cell array region MCA in the third direction D3 and extending into the second extension region EXTb, a fourth connection portion CPd extending from the fourth line portion LPd within the second extension region EXTb, a fourth pad portion PPd extending from the fourth connection portion CPd within the second extension region EXTb, and a fourth extension portion EPd extending from the fourth pad portion PPd within the second extension region EXTb. In some embodiments, the fourth line portion LPd may (at least partially) intersect (cross) the memory array region MCA in the third direction D3 from the memory cell array region MCA (or from the first extension region EXTa).

In an example embodiment, the first line portion LPa, the second line portion LPc, the third line portion LPb, and the fourth line portion LPd may be collectively referred to as a line portion LP.

In an example embodiment, the first connection portion CPa, the second connection portion CPc, the third connection portion CPb, and the fourth connection portion CPd may be collectively referred to as a connection portion CP.

In an example embodiment, the first pad portion PPa, the second pad portion PPc, the third pad portion PPb, and the fourth pad portion PPd may be collectively referred to as a pad portion PP.

In an example embodiment, the first extension portion EPa, the second extension portion EPc, the third extension portion EPb, and the fourth extension portion EPd may be collectively referred to as an extension portion EP.

The first and second line portions LPa and LPc may have a line shape extending in the first direction D1.

Lengths in the first direction D1 of the first and second line portions LPa and LPc may be different from each other. In some embodiments, ends LPa_e and LPc_e of the first and second line portions LPa and LPc may be disposed in different positions within the second extension region EXTb (see FIG. 1). For example, the second end LPc_e of the second line portion LPc may be disposed between the third extension portion EPb of the third bitline BL3 and the fourth extension portion EPd of the fourth bitline BL4 (in the second direction D2). The first end LPa_e of the first line portion LPa may be disposed between the third line portion LPb of the third bitline BL3 and the fourth line portion LPd of the fourth bitline BL4 (in the second direction D2). That is, a length in the first direction D1 of the second line portion LPc may be longer than a length in the first direction D1 of the first line portion LPa. In some embodiments, a length of the second line portion LPc may be longer than a length of the first line portion LPa in the length direction. In some embodiments, the second line portion LPc may have a portion overlapping the third extension portion EPb and the fourth extension portion EPd in the second direction D2. The first line portion LPa may not overlap the third extension portion EPb and the fourth extension portion EPd in the second direction D2.

A first end LPa_e may have a concave shape in the first direction D1. The second end LPc_e may have a convex shape in the third direction D3.

A width in the second direction D2 of the first pad portion PPa may be greater than a width in the second direction D2 of the first line portion LPa. A width in the second direction D2 of the second pad portion PPc may be greater than a width in the second direction D2 of the second line portion LPc.

Widths in the second direction D2 of the first and second pad portions PPa and PPc may be formed in a direction away from each other.

Each of the first and second connection portions CPa and CPc may have a shape of which a width (in the second direction D2) thereof gradually increases in a direction away from the memory cell array region MCA. For example, the width of the first and second connection portions CPa and CPc may increase in a horizontal direction away from each other.

The first extension portion EPa may be physically connected to an end of the first pad portion PPa, and the second extension portion EPc may be physically connected to an end of the second pad portion PPc. Each of the first and second extension portions EPa and EPc may have a shape of which a width (in the second direction D2) thereof gradually decreases in a direction away from the memory cell array region MCA.

In the first side s1 adjacent to (facing) the third bitline BL3, a side surface of the first line portion LPa may be coplanar with each of side surfaces of the first connection portion CPa, the first pad portion PPa, and the first extension portion EPa. In some embodiments, In the first side s1 , the side surface of the first line portion LPa may be aligned with each of side surfaces of the first connection portion CPa, the first pad portion PPa, and the first extension portion EPa in the second direction D2.

The first connection portion CPa may extend in a curved shape from the first line portion LPa to the first pad portion PPa in the second direction D2 such that a width thereof increases on the second side s2, which is an opposite side (in the second direction D2) of the first side s1.

The first extension portion EPa may extend in a curved shape from the first pad portion PPa in the first direction D1 such that a width thereof decreases in the second direction D2 on the second side s2.

A side surface of the second line portion LPc may be coplanar with each of side surfaces of the second connection portion CPc, the second pad portion PPc, and the second extension portion EPc on the third side s3 adjacent to (facing) the third bitline BL3. In some embodiments, the side surface of the second line portion LPc may be aligned with each of side surfaces of the second connection portion CPc, the second pad portion PPc, and the second extension portion EPc in the second direction D2 on the third side s3.

The second connection portion CPc may extend in a curved shape from the second line portion LPc to the second pad portion PPc such that a width thereof in the second direction D2 increases on the fourth side s4, which is the opposite side (in the second direction D2) of the third side s3.

The second extension portion EPc may extend in a curved shape in the first direction D1 such that a width in the second direction D2 thereof decreases from the second pad portion PPc on the fourth side s4.

The third and fourth line portions LPb and LPd may be line shapes extending in the third direction D3.

Lengths in the third direction D3 of the third and fourth line portions LPb and LPd may be different from each other. In some embodiments, ends LPb_e and LPd_e of the third and fourth line portions LPb and LPd may be disposed in different positions within the first extension region EXTa. For example, the third end LPb_e of the third line portion LPb may be disposed between the first extension portion EPa of the first bitline BL1 and the second extension portion EPc of the second bitline BL2 (in the second direction D2). The fourth end LPd_e of the fourth line portion LPd may be disposed between the first line portion LPa of the first bitline BL1 and the second line portion LPc of the second bitline BL2 (in the second direction D2). That is, a length in the third direction D3 of the third line portion LPb may be longer than a length in the third direction D3 of the fourth line portion LPd. In some embodiments, a length of the third line portion LPb may be longer than a length of the fourth line portion LPd in the length direction. In some embodiments, the third line portion LPb may have a portion overlapping the first extension portion EPa and the second extension portion EPc in the second direction D2. The fourth line portion LPd may not overlap the first extension portion EPa and the second extension portion EPc in the second direction D2.

The third end LPb_e may have a convex shape in the first direction D1. The fourth end LPd_e may have a concave shape in the third direction D3.

A width in the second direction D2 of the third pad portion PPb may be greater than a width in the second direction D2 of the third line portion LPb. A width in the second direction D2 of the fourth pad portion PPd may be greater than a width in the second direction D2 of the fourth line portion LPd.

Widths in the second direction D2 of the third and fourth pad portions PPb and PPd may be formed in a direction away from each other.

Each of the third and fourth connection portions CPb and CPd may have a shape of which a width thereof gradually increases in a direction away from the memory cell array region MCA. For example, the width of the third and fourth connection portions CPb and CPd may increase in a horizontal direction away from each other.

The third extension portion EPb may be physically connected to an end of the third pad portion PPb, and the fourth extension portion EPd may be physically connected to an end of the fourth pad portion PPd. Each of the third and fourth extension portions EPb and EPd may have a shape of which a width thereof gradually decreases in a direction away from the memory cell array region MCA.

A side surface of the third line portion LPb may be coplanar with each of side surfaces of the third connection portion CPb, the third pad portion PPb, and the third extension portion EPb on the side adjacent to (facing) the second bitline BL2. In some embodiments, the side surface of the third line portion LPb may be aligned with each of side surfaces of the third connection portion CPb, the third pad portion PPb, and the third extension portion EPb in the second direction D2 on the side adjacent to (facing) the second bitline BL2.

The third connection portion CPb may extend in a curved shape from the third line portion LPb to the third pad portion PPb such that a width in the second direction D2 increases on the side opposite to the side adjacent to (facing) the second bitline BL2 (in the second direction D2).

The third extension portion EPb may extend in a curved shape from the third pad portion PPb in the third direction D3 such that the width in the second direction D2 decreases on the opposite side (to the side adjacent to (facing) the second bitline BL2 in the second direction D2).

A side surface of the fourth line portion LPd may be coplanar with each of side surfaces of the fourth connection portion CPd, the fourth pad portion PPd, and the fourth extension portion EPd on the side adjacent to (facing) the second bitline BL2. In some embodiments, the side surface of the fourth line portion LPd may be aligned with each of side surfaces of the fourth connection portion CPd, the fourth pad portion PPd, and the fourth extension portion EPd in the second direction D2 on the side adjacent to (facing) the second bitline BL2. In a similar aspect as above, characteristics of the fourth connection portion CPd and the fourth extension portion EPd may be described.

The bitlines BL may include at least one bitline group. The first, second, third, and fourth bitlines BL1, BL2, BL3, and BL4, adjacent to each other in the second direction D2, may be included in at least one bitline group (e.g., BG1). For example, the first bitline group BG1 may include the first and second bitlines BL1 and BL2, adjacent to each other with respect to the third bitline BL3, the third bitline BL3, and the fourth bitline BL4, which is on the opposite side of the third bitline BL3 with respect to the second bitline BL2 (in the second direction D2).

The at least one bitline group may include a plurality of bitline groups (e.g., BG1 and BG2), each arranged in the second direction D2. The bitline group adjacent to the first bitline group BG1 in the second direction D2 may be referred to as the second bitline group BG2.

In some embodiments, each of the plurality of bitline groups (e.g., BG1 and BG2) may be a basic unit of the bitlines BL, and may be arranged repeatedly in the second direction D2.

The semiconductor device 1 may further include active regions ACT and device isolation regions STla and STIb.

The active regions ACT may be disposed on the substrate SUB within the memory cell array region MCA. The active regions ACT may have a shape protruding from the substrate SUB in the vertical direction Z. The active regions ACT may be formed of a semiconductor device material the same as that of the substrate SUB, for example, single crystal silicon.

Each of the active regions ACT may have a bar shape extending in the second direction D2 and an inclined direction as in FIGS. 2 and 3B, but an example embodiment thereof is not limited thereto, and the shapes of the active regions ACT may be varied.

The active regions ACT may include dummy active regions ACTd adjacent to the first and second extension regions EXTa and EXTb.

The device isolation regions STIa and STIb may include a cell device isolation region STIc disposed on a side surface of the cell active regions ACTc within the memory cell array region MCA, and a peripheral device isolation region STIb disposed on the substrate SUB within the first and second extension regions EXTa and EXTb. The device isolation regions STIa and STIb may include (e.g., may be formed of) an insulating material, such as silicon oxide and/or silicon nitride.

The semiconductor device 1 may further include gate trenches GT crossing (e.g., overlapping in the vertical direction Z) the cell active regions ACTc and the cell device isolation region STIc. Each of the gate trenches GT may have a line shape extending in the second direction D2.

The semiconductor device 1 may further include gate structures GS and gate capping layers GC on the gate structures GS.

The gate structures GS and the gate capping layers GC may be disposed in the gate trenches GT.

Each of the gate structures GS may include a gate dielectric layer Gox and a gate electrode GE. In each of the gate structures GS, the gate dielectric layer Gox may be disposed on an inner wall of the gate trench GT, and the gate electrode GE may partially fill the gate trench GT on the gate dielectric layer Gox. The gate capping layer GC may (at least partially) fill the other portion of the gate trench GT on the gate electrode GE. The gate electrode GE and the gate capping layer GC may be stacked one after the other. An upper surface of the gate electrode GE may be disposed at a level higher than a level of upper surfaces of the active regions ACT. Herein, the term "level", "vertical level", "height", or the like may refer to a relative location with respect to a reference element in the vertical direction Z. A level, a vertical level, height, or the like may be a distance from the upper surface of the substrate SUB in the vertical direction Z. For example, a higher level may mean a farther distance from the upper surface of the substrate SUB in the vertical direction Z, and a lower level may mean a closer distance to the upper surface of the substrate SUB in the vertical direction Z.

The gate dielectric layer Gox may be disposed between a lower surface (e.g., a bottom surface) of the gate electrode GE and a lower surface (e.g., a bottom surface) of the gate trench GT, between a side surface of the gate electrode GE and a sidewall of the gate trench GT, and between a side surface of the gate capping layer GC and a sidewall of the gate trench GT.

Each of the active regions ACT may include first and second source/drain regions SD1 and SD2 (in the upper region of the active region ACT) spaced apart from each other by the gate trench GT. The gate capping layer GC may be disposed between the first and second source/drain regions SD1 and SD2.

In an example embodiment, the gate electrode GE, the gate dielectric layer Gox, and the first and second source/drain regions SD1 and SD2 may be included in a cell transistor TR.

In an example embodiment, the bitlines BL may be disposed at a level different from a level of the gate structures GS. For example, the gate structures GS may be disposed at a level lower than a level of the bitlines BL.

The gate structures GS may be adjacent to the first and second extension regions EXTa and EXTb and may include dummy gate structures GSd, electrically isolated. The dummy gate structures GSd may cross (e.g., overlap in the vertical direction Z) the dummy active regions ACTd.

The semiconductor device 1 may further include a buffer insulating structure 6 on the active regions ACTc, the device isolation regions STIa and STIb, the gate structures GS, and the gate capping layers GC. The buffer insulating structure 6 may include at least one insulating material. For example, the buffer insulating structure 6 may include a first insulating layer 6a, a second insulating layer 6b, and a third insulating layer 6c, stacked in order. The first and third insulating layers 6a and 6c may be formed of silicon oxide, and the second insulating layer 6b may be formed of silicon nitride.

The bitlines BL may be disposed on the buffer insulating structure 6.

The semiconductor device 1 may further include bitline plugs BLP (electrically) connecting the bitlines BL to the first source/drain regions SD1.

Each of the bitlines BL may include at least one conductive material layer. For example, each of the conductive lines BL may include (e.g., may be formed of) doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, graphene, carbon nanotube, and/or a combination thereof, but an example embodiment thereof is not limited thereto. Each of the bitlines BL may include a single layer or multiple layers of the materials described above. For example, each of the bitlines BL may include a first conductive material layer 12a, a second conductive material layer 12b on the first conductive material layer 12a, and a third conductive material layer 12c on the second conductive material layer 12b. The first, second, and third conductive material layers 12a, 12b, and 12c may include different materials. The bitline plugs BLP may extend from the bitlines BL, may extend into (e.g., penetrate) the buffer insulating structure 6, and may be electrically connected to the first source/drain regions SD1 of the active regions ACT. The bitline plugs BLP may include (e.g., may be formed of) the same material as the first conductive material layer 12a, but an example embodiment thereof is not limited thereto. For example, the bitline plugs BLP may include (e.g., may be formed of) a conductive material different from that of the first conductive material layer 12a.

The semiconductor device 1 may further include bitline capping patterns BLc on the bitlines BL.

The bitlines BL, the bitline plugs BLP, and the bitline capping patterns BLc may be included in bitline structures BLS.

Each of the bitline capping patterns BLc may include an insulating material, such as silicon nitride. Each of the bitline capping patterns BLc may include at least one insulating material layer. For example, each of the bitline capping patterns BLc may include a first insulating material layer 15, a second insulating material layer 21 on the first insulating material layer 15, and a third insulating material layer 27 on the second insulating material layer 21. In each of the bitline capping patterns BLc, a thickness of the second insulating material layer 21 may be less (smaller) than a thickness of each of the first and third insulating material layers 15 and 27.

The semiconductor device 1 may further include an insulating pattern ES.

The insulating pattern ES may include a first insulating pattern 16 disposed on a side surface of at least a portion of bitlines BL within the first and second extension regions EXTa and EXTb, a second insulating pattern 18 disposed on a side surface of the first insulating pattern 16, and a third insulating pattern 21e disposed on an upper surface and a side surface of the second insulating pattern 18.

The first insulating pattern 16 may include a first portion 16a on a side surface of the first pad portion PPa and a side surface of the first extension portion EPa.

The first insulating pattern 16 may further include a second portion 16b on a side surface of the second pad portion PPc and a side surface of the second extension portion EPc.

The first insulating pattern 16 may further include a third portion 16c on (a side surface of) an end of the third line portion LPb.

The first insulating pattern 16 may further include a fourth portion 16d on (a side surface of) an end of the fourth line portion LPd.

The first insulating pattern 16 may include, for example, a low-κ dielectric, silicon oxide, and/or silicon nitride. The first insulating pattern 16 may include, for example, silicon nitride. The first insulating pattern 16 may include at least one insulating layer. The first insulating pattern 16 may be formed as a single layer or multiple layers.

The first insulating pattern 16 may be on (e.g., may cover overlap) side surfaces of the first insulating material layers 15 aligned with the pad portions PP.

The second insulating pattern 18 may be on (e.g., may cover or overlap) a side surface of the first insulating pattern 16. The second insulating pattern 18 may include, for example, a low-κ dielectric, silicon oxide, and/or silicon nitride. The second insulating pattern 18 may include, for example, silicon oxide.

The third insulating pattern 21e may extend from the second insulating material layers 21 and may be on (e.g., may cover or overlap) an upper surface and a side surface of the second insulating pattern 18. The third insulating pattern 21e may be disposed on the peripheral device isolation region STIb. The third insulating pattern 21e may include, for example, a low-κ dielectric, silicon oxide, and/or silicon nitride. For example, the third insulating pattern 21e may include silicon nitride. The third insulating pattern 21e may be referred to as an insulating liner.

The semiconductor device 1 may further include a lower interlayer insulating layer 24 disposed on the third insulating pattern 21e and coplanar with upper surfaces of the second insulating material layers 21. The lower interlayer insulating layer 24 may include an insulating material such as silicon oxide and/or a low-κ dielectric.

The semiconductor device 1 may further include an upper interlayer insulating layer 27e extending from the third insulating material layers 27 and disposed on a lower interlayer insulating layer 24. A material of the upper interlayer insulating layer 27e may be different from a material of the lower interlayer insulating layer 24. For example, the lower interlayer insulating layer 24 may include silicon oxide and/or a low-κ dielectric, and the upper interlayer insulating layer 27e may include silicon nitride.

The semiconductor device 1 may further include insulating structures 33p disposed in the first and second extension regions EXTa and EXTb, and at least a portion disposed between the bitlines BL. The insulating structures 33p may be spaced apart from each other in the second direction D2. The insulating structures 33p may include an insulating material, such as silicon oxide and/or silicon nitride.

The insulating structure 33p may include a first insulating structure 33p1 extending in the first direction D1 between first and third bitlines BL1 and BL3 adjacent to each other and between second and third bitlines BL2 and BL3 adjacent to each other, and a second insulating structure 33p2 disposed between first and fourth bitlines BL1 and BL4 adjacent to each other and between second and fourth bitlines BL2 and BL4 adjacent to each other.

The first insulating structure 33p1 may include a first insulating portion 33p1a disposed between the first and third bitlines BL1 and BL3 adjacent to each other and between the second and third bitlines BL2 and BL3 adjacent to each other.

The first insulating structure 33p1 may further include a first extension insulating portion 33p1b extending from the first insulating portion 33p1a in a direction away from the memory cell array region MCA. The first extension insulating portion 33p1b may extend through the insulating pattern ES and may extend into the lower interlayer insulating layer 24. By the first extension insulating portion 33p1b, first, second, and third portions 16a, 16b, and 16c of the first insulating pattern 16 may be defined.

The second insulating structure 33p2 may include a second insulating portion 33p2a disposed between the first and fourth bitlines BL1 and BL4 adjacent to each other and between the second and fourth bitlines BL2 and BL4 adjacent to each other.

The second insulating structure 33p2 may further include a second extension insulating portion 33p2b extending from the second insulating portion 33p2a through the insulating pattern ES. The second and fourth portions 16b and 16d of the first insulating pattern 16 may be defined by the second extension insulating portion 33p2b.

The insulating structure 33p may include, for example, a low-κ dielectric, silicon oxide, and/or silicon nitride. The low-κ dielectric may be a dielectric having a dielectric constant lower than a dielectric constant of silicon oxide.

The semiconductor device 1 may further include a spacer structure SP. The spacer structure SP may be formed of an insulating material.

The spacer structure SP may include plug spacers 36, inner spacers 30, outer spacers 45 and intermediate spacers 42.

The plug spacers 36 may be disposed on side surfaces of the bitline plugs BLP. Each of the plug spacers 36 may include a spacer pattern 36b and a spacer liner 36a on (e.g., covering or overlapping) a side surface and a lower surface of the spacer pattern 36b in a cross-sectional structure as in FIG. 4D.

The inner spacers 30 may be disposed on side surfaces of the bitline structures BLS. The inner spacers 30 may be on (e.g., may cover or overlap) side surfaces and lower surfaces of the plug spacers 36 and may be on (e.g., may cover or overlap) side surfaces of the bitlines BL and side surfaces of the bitline capping patterns BLc. The intermediate and outer spacers 42 and 45 may be disposed on the side surfaces of the bitlines BL and the side surfaces of the bitline capping patterns BLc.

The inner spacers 30 may be in contact with the bitlines BL. The intermediate spacers 42 may be disposed between the inner spacers 30 and the outer spacers 45.

The inner spacers 30 may include, for example, SiN and/or SiCN.

The intermediate spacers 42 may include, for example, silicon oxide and/or low-κ dielectric.

The outer spacers 45 may include, for example, SiN and/or SiCN.

The semiconductor device 1 may further include contact plugs CNT disposed between the bitline structures BLS.

The contact plugs CNT may include (e.g., may be formed of) a conductive material.

The contact plugs CNT may include cell contact plugs CNTc disposed in the memory cell array region MCA and electrically connected to the second source/drain regions SD2, and dummy contact plugs CNTd disposed in the first and second extension regions EXTa and EXTb and disposed on the peripheral device isolation region STIb. The dummy contact plugs CNTd may be in contact with the peripheral device isolation region STIb and may be electrically isolated.

Within the first and second extension regions EXTa and EXTb, the dummy contact plugs CNTd may prevent deformation of the bitline structures BLS.

Each of the contact plugs CNT may include a lower conductive layer 55, an upper conductive layer 64 on the lower conductive layer 55, and an intermediate conductive layer 61 between the lower conductive layer 55 and the upper conductive layer 64.

The lower conductive layer 55 may include doped polysilicon, for example, polysilicon having an N-type conductivity. The intermediate conductive layer 61 may include a metal-semiconductor device compound layer. The upper conductive layer 64 may include a barrier layer 64a on (e.g., covering or overlapping) a side surface and a lower surface (e.g., a bottom surface) of the conductive layer 64b and the conductive layer 64b. The barrier layer 64a may include, for example, TiN, TaN, WN, TiSiN, TaSiN, and/or RuTiN, and the conductive layer 64b may include a metal material such as W.

The lower conductive layers 55 of the cell contact plugs CNTc may be in contact with the second source/drain regions SD2, and the lower conductive layers 55 of the dummy contact plugs CNTd may be in contact with the peripheral device isolation region STIb.

The semiconductor device 1 may further include an upper spacer 58 extending around (e.g., surrounding) a side surface of the upper conductive layer 64. The upper spacer 58 may include an insulating material such as silicon oxide or silicon nitride.

The semiconductor device 1 may further include insulating fences IF parallel to each other. Each of the insulating fences IF may have a line shape extending in the second direction D2. The insulating fences IF may overlap the gate structures GS perpendicularly within the memory cell array region MCA, and may be in contact with the peripheral device isolation region STIb within the first and second extension regions EXTa and EXTb.

Each of the insulating fences IF may include first fence portions IFa and second fence portions IFb. The insulating fences IF may include (e.g., may be formed of) an insulating material such as silicon nitride or silicon oxide.

The first fence portions IFa may (electrically) isolate the cell contact plugs CNTc from each other in the first direction D1 within the memory cell array region MCA. The first fence portions IFa may (electrically) isolate the dummy contact plugs CNTd from each other in the first direction D1 within the memory cell array region MCA. The second fence portions IFb may be disposed at a level higher than a level of the bitlines BL and may extend into (e.g., penetrate) a portion of the bitline capping patterns BLc and may extend from upper regions of the first fence portions IFa.

The contact plugs CNT may be spaced apart from each other in the second direction D2 by the bitline structures BLS, and may be spaced apart from each other in the first direction D1 by the first fence portions IFa of the insulating fences IF.

The semiconductor device 1 may further include bitline contact structures 72 (e.g. plugs). The bitline contact structures 72 may extend into (e.g., penetrate) the bitline capping patterns BLc within the first and second extension regions EXTa and EXTb and may be electrically connected to the pad portions PP of the bitlines BL.

Among the bitline contact structures 72, the bitline contact structures 72 disposed in the first extension region EXTa may include, for example, a first bitline contact structure 72a extending into (e.g., penetrating) the bitline capping pattern BLc and electrically connected to the first pad portion PPa of the first bitline BL1. A central portion (e.g., the center) of the first bitline contact structure 72a and a central portion (e.g., the center) of the first pad portion PPa may be aligned with each other in the first direction D1.

Among the bitline contact structures 72, the bitline contact structures 72 disposed in the first extension region EXTa may include, for example, a second bitline contact structure 72b extending into (e.g., penetrating) the bitline capping pattern BLc and electrically connected to the second pad portion PPc of the second bitline BL2. A central portion (e.g., the center) of the second bitline contact structure 72b and a central portion (e.g., the center) of the second pad portion PPc may be aligned with each other in the first direction D1.

Each of the bitline contact structures 72 may include a first conductive layer 72_1 and a second conductive layer 72_2 on (e.g., covering or overlapping) a side surface and a lower surface (e.g., a bottom surface) of the first conductive layer 72_1. The second conductive layer 72_2 may include, for example, TiN, TaN, WN, TiSiN, TaSiN, and/or RuTiN, and the first conductive layer 72_1 may include a metal material such as W.

The semiconductor device 1 may further include conductive patterns 75i and 75p. Each of the conductive patterns 75i and 75p may include at least one conductive material. Each of the conductive patterns 75i and 75p may include, for example, Cu, Ti, Ta, Ru, W, Mo, Pt, Ni, Co, TiN, TaN, WN, NbN, TiAl, TiAlN, TiSi, TiSiN, TaSi, TaSiN, RuTiN, and/or NiSi.

The conductive patterns 75i and 75p may include first conductive patterns 75i connected to the bitline contact structures 72 within the first and second extension regions EXTa and EXTb and extending to the upper interlayer insulating layer 27e and second conductive patterns 75p electrically connected to the cell contact plugs CNTc within the memory cell array region MCA.

The first conductive patterns 75i may be configured as interconnection lines for electrically connecting the bitlines BL to peripheral circuits such as sense amplifiers. The second conductive patterns 75p may be configured as landing pads. The second conductive patterns 75p may be electrically connected to the second source/drain regions SD2 of the cell transistors TR by the cell contact plugs CNTc.

The first conductive patterns 75i may be referred to as 'bitline interconnection lines' or 'interconnection lines,' and the second conductive patterns 75p may be referred to as 'conductive pads.'

The semiconductor device 1 may further include an insulating isolation pattern 78, an etch-stop layer 85, a data storage structure DS, and a peripheral insulating layer 95.

The insulating isolation pattern 78 may be disposed on side surfaces of the conductive patterns 75i and 75p and may extend downwardly. The insulating isolation pattern 78 may be disposed at a level higher than a level of the bitlines BL. Upper surfaces of the dummy contact plugs CNTd may be covered by the insulating isolation pattern 78.

The etch-stop layer 85 may be disposed on the insulating isolation pattern 78 and the conductive patterns 75i and 75p and may include (e.g., may be formed of) an insulating material. The peripheral insulating layer 95 may be disposed on the etch-stop layer 85 within the first and second extension regions EXTa and EXTb.

The data storage structure DS may be disposed in the memory cell array region MCA.

In an example, the data storage structure DS may be configured as a capacitor configured to store data in a DRAM. For example, the data storage structure DS may be configured as a capacitor of a DRAM including first electrodes 88 extending into (e.g., penetrating) the etch-stop layer 85 and electrically connected to the second conductive patterns 75p, a dielectric layer 90 on (e.g., covering or overlapping) the first electrodes 88 and the etch-stop layer 85, and a second electrode 92 on the dielectric layer 90. The dielectric layer 90 may include, for example, a high-κ dielectric, silicon oxide, silicon nitride, silicon oxynitride, and/or a combination thereof. The high-κ dielectric may have a dielectric constant higher than a dielectric constant of silicon oxide.

In some embodiments, the data storage structure DS may be configured to store data of a memory other than a DRAM. For example, in the data storage structure DS, the dielectric layer 90 may include a ferroelectric layer for recording data using a polarization state.

In example embodiments, a patterning process to form bitlines BL may be performed, and an insulating pattern may be disposed at ends of line portions LP of the bitlines BL. For example, after performing the patterning process, the insulating pattern (first and second portions of the first insulating pattern) 16a, 16b may be disposed at ends LPa_e and LPc_e of first and second line portions LPa and LPc, and the insulating pattern (third and fourth portions of the first insulating pattern) 16c, 16d may be disposed at ends LPb_e and LPd_e of third and fourth line portions LPb and LPd. Accordingly, a semiconductor device 1 including bitlines BL of which degradation is reduced or prevented may be provided.

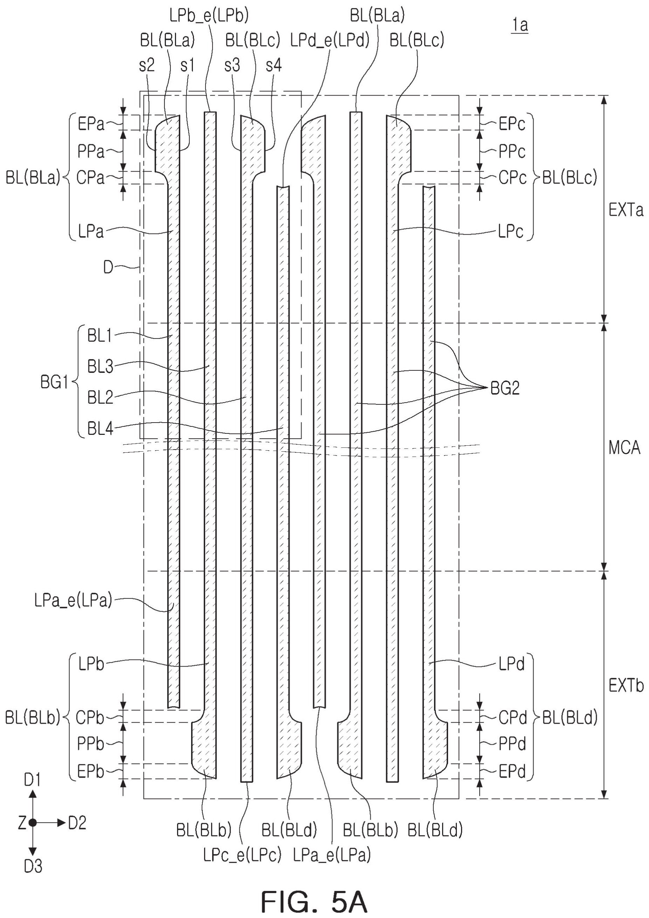

FIG. 5A is a plan diagram illustrating a semiconductor device according to an example embodiment.

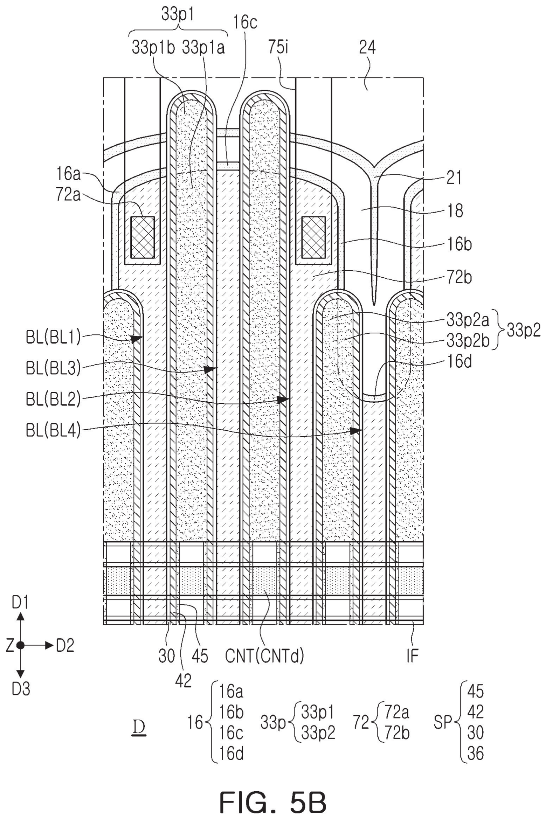

FIG. 5B is an enlarged diagram illustrating region 'D' illustrated in FIG. 5A.

Referring to FIGS. 5A and 5B, a semiconductor device 1a may be configured the same as or (substantially) similar to the example described with reference to FIGS. 1, 2, 3A, 3B, 4A, 4B, 4C, 4D, and 4E, other than the configuration in which a pad portion PP having a width smaller than the width in the length direction (e.g., the first direction D1 and/or the third direction D3) of the pad portion PP of each of bitlines BL of the semiconductor device 1 described with reference to FIGS. 1, 2, 3A, 3B, 4A, 4B, 4C, 4D, and 4E is included.

A curvature of the ends LPc_e and LPb_e of the second and third line portions LPc and LPb of the second and third bitlines BL2 and BL3 of the semiconductor device 1a may be smaller than a curvature of the ends LPc_e and LPb_e described with reference to FIGS. 1, 2, 3A, 3B, 4A, 4B, 4C, 4D, and 4E. For example, the ends LPc_e and LPb_e in the example embodiment may be (substantially) flat.

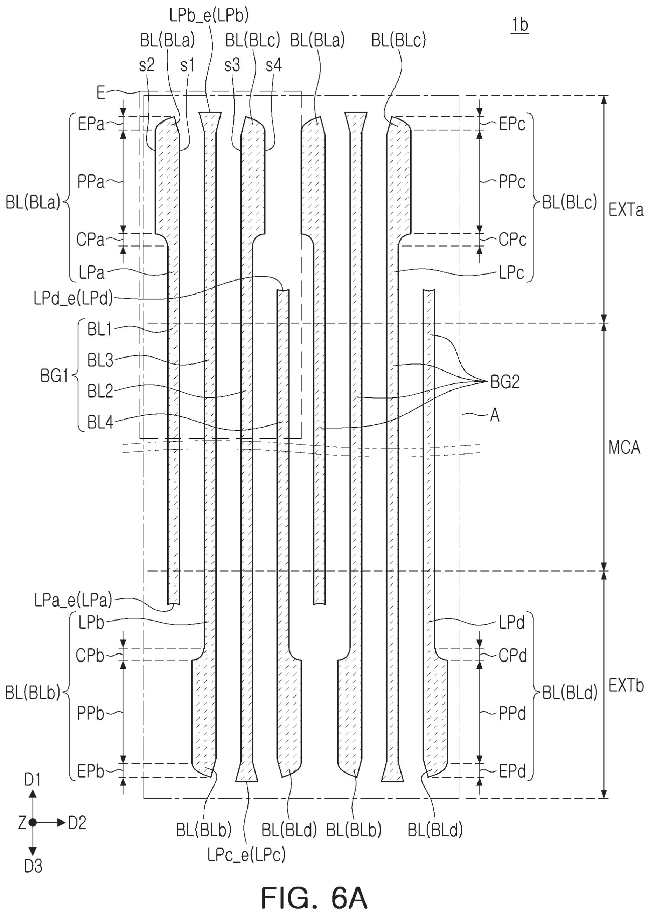

FIG. 6A is a plan diagram illustrating a semiconductor device according to an example embodiment.

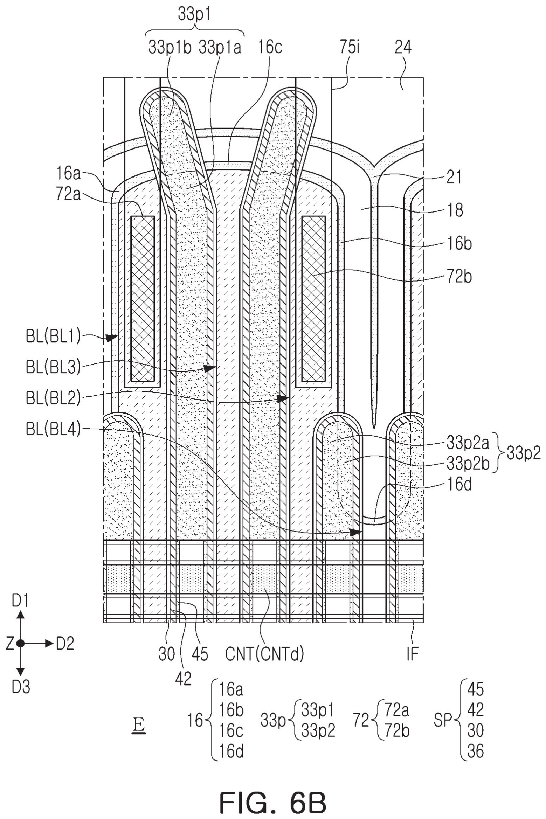

FIG. 6B is an enlarged diagram illustrating region 'E' illustrated in FIG. 6A.

Referring to FIGS. 6A and 6B, a semiconductor device 1b may be configured the same as or (substantially) similar to the example described with reference to FIGS. 1, 2, 3A, 3B, 4A, 4B, 4C, 4D, 5A, and 5B, other than the configuration in which the second and third line portions LPc and LPb of which the width in the second direction D2 increases in the length direction is included.

In the example embodiment, the insulating structure 33p may include portions bent in a direction away from each other. An end portion of the first insulating portion 33p1a of the first insulating structure 33p1 and an end portion of the second insulating portion 33p2a of the second insulating structure 33p2 may be bent in a direction diagonally away from each other. Accordingly, the width in the second direction D2 of the second and third line portions LPc and LPb may increase in the length direction.

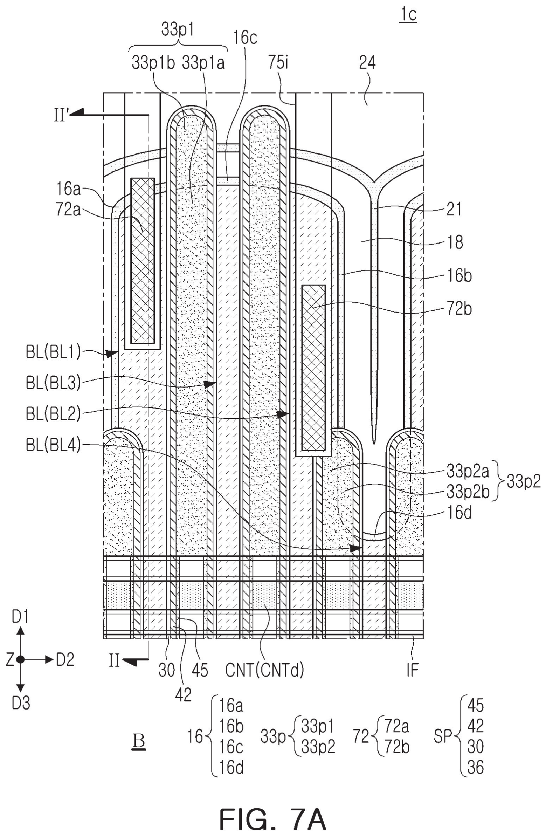

FIG. 7A is a plan diagram illustrating a semiconductor device according to an example.

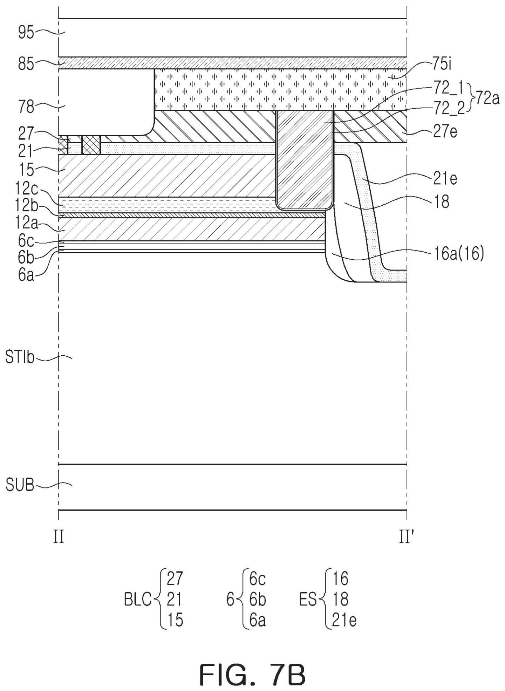

FIG. 7B is a cross-sectional diagram illustrating a region taken along line II-II' in FIG. 3A.

Referring to FIGS. 7A and 7B, a semiconductor device 1c may be configured the same as or (substantially) similar to the example described with reference to FIGS. 1, 2, 3A, 3B, 4A, 4B, 4C, 4D, 5A, 5B, 6A, and6B, other than the configuration in which bitline contact structures 72 of which (at least some of) respective central portions (e.g., the centers) are misaligned in the second direction D2 are included.

The central portions (e.g., the centers) of the bitline contact structures 72 may be misaligned in the second direction D2. In another aspect, the bitline contact structures 72 may be arranged in a zigzag manner in the second direction D2.

The end of the first direction D1 of the first bitline contact structure 72a may be in contact with, for example, at least a portion of the insulating pattern ES. Accordingly, a portion of the first bitline contact structure 72a may be in contact with the first extension portion EPa.

The first bitline contact structure 72a may be in contact with, for example, the first and second insulating patterns 16 and 18 of the insulating pattern ES, but an example embodiment thereof is not limited thereto. The first bitline contact structure 72a may also be in contact with, for example, the third insulating pattern 21e of the insulating pattern ES. The first bitline contact structure 72a may also be in contact with, for example, the lower interlayer insulating layer 24 of the insulating pattern ES.

The end of the second direction D2 of the second bitline contact structure 72b may be in contact with, for example, at least a portion of the second insulating structure 33p2 of the insulating structure 33p. Accordingly, a portion of the second bitline contact structure 72b may be in contact with the second line portion LPc.

The second bitline contact structure 72b may be in contact with, for example, an inner spacer 30, intermediate and the outer spacers 42 and 45 of the second insulating structure 33p2.

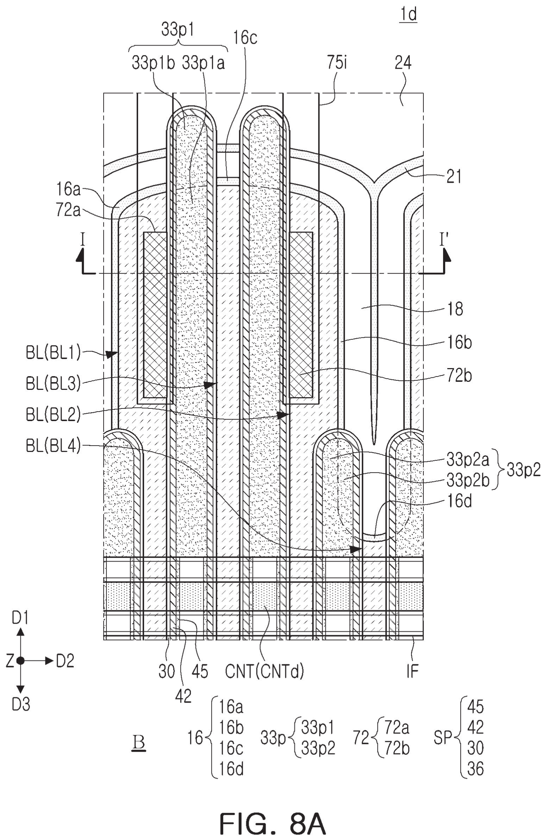

FIG. 8A is a plan diagram illustrating a semiconductor device according to an example.

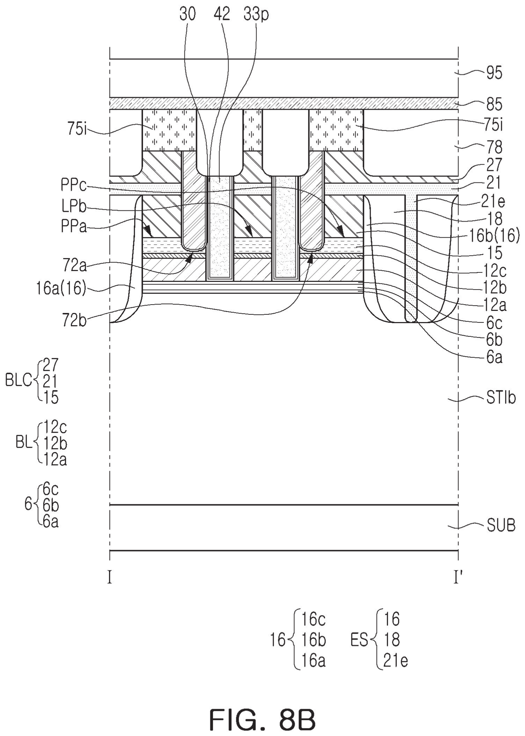

FIG. 8B is a cross-sectional diagram illustrating regions taken along line I-I' in FIG. 8A.

Referring to FIGS. 8A and 8B, a semiconductor device 1d may be configured the same as or (substantially) similar to the example described with reference to FIGS. 1, 2, 3A, 3B, 4A, 4B, 4C, 4D, 5A, 5B, 6A, 6B, 7A, and 7B, other than the configuration in which bitline contact structures 72 having central portions (e.g., centers) aligned with the central portions (e.g., centers) of the first and second line portions LPa and LPc in the first direction D1 are included.

The central portions (e.g., centers) of the bitline contact structures 72 may be aligned with the central portions (e.g., centers) of the first and second line portions LPa and LPc in the first direction D1.

In the second direction D2, the side surface (at least one of the side surfaces) of the first bitline contact structure 72a may be misaligned with the side surface (at least one of the side surfaces) of the first pad portion PPa. In a planar view, at least a portion of the first bitline contact structure 72a may not overlap the first pad portion PPa.

The first bitline contact structure 72a may be in contact with, for example, the inner spacer 30 adjacent to the first bitline BL1, but an example embodiment thereof is not limited thereto. The first bitline contact structure 72a may be in contact with, for example, the intermediate spacer 42 of the first bitline BL1, and/or at least a portion of the first insulating structure 33p1.

The side surface (at least one of the side surfaces) of the second bitline contact structure 72b may be misaligned with the side surface (at least one of the side surfaces) of the second pad portion PPc in the second direction D2. In a planar view, at least a portion of the second bitline contact structure 72b may not overlap the second pad portion PPc.

The second bitline contact structure 72b may be in contact with, for example, the inner spacer 30 adjacent to the second bitline BL2, but an example embodiment thereof is not limited thereto. The second bitline contact structure 72b may be in contact with, for example, the intermediate spacer 42 adjacent to the second bitline BL2 and/or at least a portion of the first insulating structure 33p1.

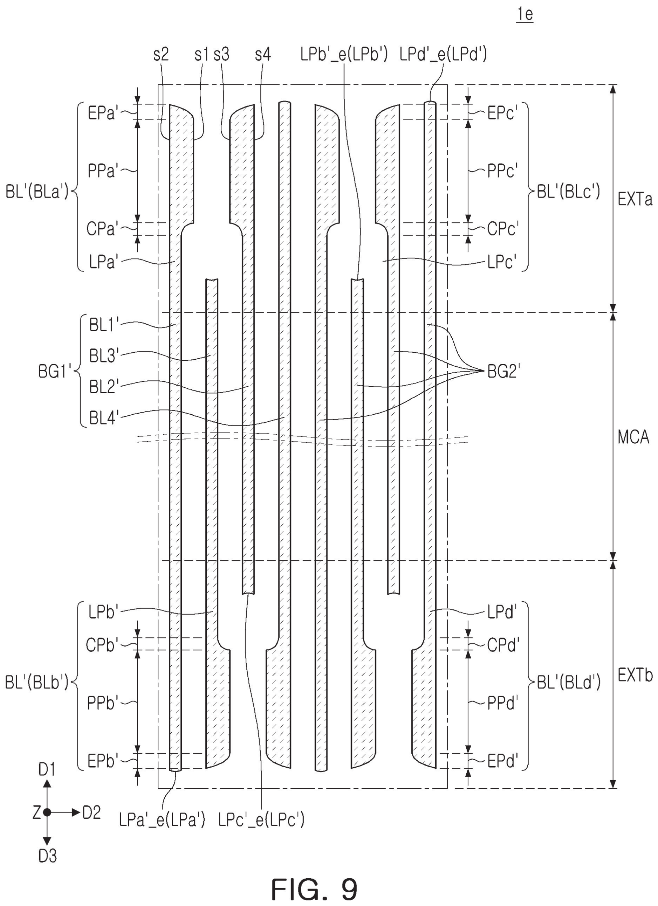

FIG. 9 is a plan diagram illustrating a semiconductor device according to an example.

Referring to FIG. 9, bitlines BL' of a semiconductor device 1e may be configured the same as or (substantially) similar to the example described with reference to FIGS. 1, 2, 3A, 3B, 4A, 4B, 4C, 4D, 5A, 5B, 6A, 6B, 7A, 7B, 8A, and 8B, other than the configuration in which the bitlines BL' may be defined from a different perspective from the bitlines BL of the semiconductor device 1, 1a, 1b, 1c, and 1d described with reference to FIGS. 1, 2, 3A, 3B, 4A, 4B, 4C, 4D, 5A, 5B, 6A, 6B, 7A, 7B, 8A, and 8B.

The bitlines BL' arranged and spaced apart from each other in the horizontal direction (e.g., the second direction D2) may be configured to include 4n+1st bitlines BLa', 4n+2nd bitlines BLb', 4n+3rd bitlines BLc', and 4n+4th bitlines BLd'. Here, the index n may be a natural number including 0(zero).

Each of the 4n+1th bitlines BLa' may be referred to as the first bitline BL1'.

Each of the 4n+3rd bitlines BLc' may be referred to as the second bitline BL2'.

Each of the 4n+2nd bitlines BLb' may be referred to as the third bitline BL3'.

Each of the 4n+4th bitlines BLd' may be referred to as the fourth bitline BL4'.

The first bitline BL1' may include a first line portion LPa' intersecting (crossing) the memory cell array region MCA in a first direction D1 from the memory cell array region MCA (or from the second extension region EXTb) toward the first extension region EXTa and extending into the first extension region EXTa, a first connection portion CPa' extending from the first line portion LPa' within the first extension region EXTa, a first pad portion PPa' extending from the first connection portion CPa' within the first extension region EXTa, and a first extension portion EPa' extending from the first pad portion PPa' within the first extension region EXTa.

The second bitline BL2' may include a second line portion LPc' intersecting (crossing) the memory cell array region MCA in the first direction D1 from the memory cell array region MCA (or from the second extension region EXTb) toward the first extension region EXTa and extending into the first extension region EXTa, a second connection portion CPc' extending from the second line portion LPc' within the first extension region EXTa, a second pad portion PPc' extending from the second connection portion CPc' within the first extension region EXTa, and a second extension portion EPc' extending from the second pad portion PPc' within the first extension region EXTa.

The third bitline BL3' may be disposed between the first and second bitlines BL1', BL2' (in the second direction D2). The third bitline BL3' may include a third line portion LPb' intersecting (crossing) the memory cell array region MCA in the third direction D3 from the memory cell array region MCA (or from the first extension region EXTa) toward the second extension region EXTb and extending into the second extension region EXTb, a third connection portion CPb' extending from the third line portion LPb' within the second extension region EXTb, a third pad portion PPb' extending from the third connection portion CPb' within the second extension region EXTb, and a third extension portion EPb' extending from the third pad portion PPb' within the second extension region EXTb.

The fourth bitline BL4' may be disposed on an opposite side of the third bitline BL3' with respect to the second bitline BL2' (in the second direction D2). The fourth bitline BL4' may include a fourth line portion LPd' intersecting (crossing) the memory cell array region MCA (from the memory cell array region MCA or from the first extension region EXTa toward the second extension region EXTb) in the third direction D3 and extending into the second extension region EXTb, a fourth connection portion CPd' extending from the fourth line portion LPd' within the second extension region EXTb, a fourth pad portion PPd' extending from the fourth connection portion CPd' within the second extension region EXTb, and a fourth extension portion EPd' extending from the fourth pad portion PPd' within the second extension region EXTb.

The first and second line portions LPa' and LPc' may be line shapes extending in the first direction D1.

The lengths in the first direction D1 of the first and second line portions LPa' and LPc' may be different from each other. In some embodiments, the ends LPa'_e, LPc'_e of the first and second line portions LPa' and LPc' may be disposed in different positions within the second extension region EXTb. For example, the second end LPc'_e of the second line portion LPc' may be disposed between the third line portion LPb' of the third bitline BL3' and the fourth line portion LPd' of the fourth bitline BL4' (in the second direction D2). The first end LPa'_e of the first line portion LPa' may be disposed between the third extension portion EPb' of the third bitline BL3' and the fourth extension portion EPd' of the fourth bitline BL4' (in the second direction D2). That is, the length in the first direction D1 (or the third direction D3) of the first line portion LPa' may be longer than the length in the first direction D1 (or the third direction D3) of the second line portion LPc'. In some embodiments, the length of the first line portion LPa' may be longer than the length of the second line portion LPc' in the length direction.

The first end LPa'_e may have a convex shape in the third direction D3. The second end LPc'_e may have a concave shape in the first direction D1.

The width in the second direction D2 of the first pad portion PPa' may be greater (e.g., larger or wider) than the width in the second direction D2 of the first line portion LPa'. The width in the second direction D2 of the second pad portion PPc' may be greater (e.g., larger or wider) than the width in the second direction D2 of the second line portion LPc'.

The widths in the second direction D2 of the first and second pad portions PPa', PPc' may be formed in the direction toward each other.

Each of the first and second connection portions CPa' and CPc' may have a shape of which a width (in the second direction D2) gradually increases in a direction away from the memory cell array region MCA. For example, the width of the first and second connection portions CPa' and CPc' may increase in a horizontal direction toward each other.

The first extension portion EPa' may be physically connected to an end of the first pad portion PPa', and the second extension portion EPc' may be physically connected to an end of the second pad portion PPc'. Each of the first and second extension portions EPa' and EPc' may have a shape of which a width (in the second direction D2) gradually decreases in a direction away from the memory cell array region MCA.

The side surface of the first line portion LPa' may be coplanar with a side surface of each of the first connection portion CPa', the first pad portion PPa', and the first extension portion EPa' on the second side s2, which is an opposite side to the first side s1 (in the second direction D2) that faces the third bitline BL3' In some embodiments, the side surface of the first line portion LPa' may be aligned with the side surface of each of the first connection portion CPa', the first pad portion PPa', and the first extension portion EPa' in the second direction D2 on the second side s2.

The first connection portion CPa' may extend in a curved shape from the first line portion LPa' to the first pad portion PPa' on the first side s1, such that the width in the second direction D2 increases.

The first extension portion EPa' may extend in a curved shape from the first pad portion PPa' to the first direction D1 on the first side s1, such that the width in the second direction D2 decreases.

The side surface of the second line portion LPc' may be coplanar with a side surface of each of the second connection portion CPc', the second pad portion PPc', and the second extension portion EPc' on the fourth side s4, which is an opposite side (in the second direction D2) to the third side s3 that faces the third bitline BL3'. In some embodiments, the side surface of the second line portion LPc' may be aligned with a side surface of each of the second connection portion CPc', the second pad portion PPc', and the second extension portion EPc' in the second direction D2 on the fourth side s4.

The second connection portion CPc' may extend in a curved shape from the second line portion LPc' to the second pad portion PPc' on the third side s3 such that the width in the second direction D2 increases.

The second extension portion EPc' may extend in a curved shape from the second pad portion PPc' to the first direction D1 on the third side s3, such that the width in the second direction D2 decreases.

The third and fourth line portions LPb' and LPd' may be line shapes extending in the third direction D3.

The lengths in the third direction D3 of the third and fourth line portions LPb' and LPd' may be different from each other. In some embodiments, the ends LPb'_e, LPd'_e of the third and fourth line portions LPb' and LPd' may be disposed in different positions within the first extension region EXTa. For example, the third end LPb'_e of the third line portion LPb' may be disposed between the first line portion LPa' of the first bitline BL1' and the second line portion EPc' of the second bitline BL2' (in the second direction D2). The fourth end LPd'_e of the fourth line portion LPd' may be disposed between the first extension portion EPa' of the first bitline BL1 and the second extension portion EPc' of the second bitline BL2 (in the second direction D2). That is, the length in the third direction D3 (or the first direction D1) of the fourth line portion LPd' may be longer than the length in the third direction D3 (or the first direction D1) of the third line portion LPb'. In some embodiments, the length of the fourth line portion LPd' may be longer than the length of the third line portion LPb' in the length direction.

The fourth end LPd'_e may have a convex shape in the first direction D1. The third end LPb'_e may have a concave shape in the third direction D3.

The width in the second direction D2 of the third pad portion PPb' may be greater (e.g., larger or wider) than the width in the second direction D2 of the third line portion LPb'. The width of the second direction D2 of the fourth pad portion PPd' may be greater (e.g., larger or wider) than the width in the second direction D2 of the fourth line portion LPd'.

The widths in the second direction D2 of the third and fourth pad portions PPb', PPd' may be formed in a direction toward each other.

Each of the third and fourth connection portions CPb' and CPd' may have a shape of which a width (in the second direction D2) gradually increases in a direction away from the memory cell array region MCA. For example, the width of the third and fourth connection portions CPb' and CPd' may increase in a horizontal direction toward each other.

The third extension portion EPb' may be physically connected to an end of the third pad portion PPb', and the fourth extension portion EPd' may be physically connected to an end of the fourth pad portion PPd'. Each of the third and fourth extension portions EPb' and EPd' may have a shape of which a width (in the second direction D2) gradually decreases in a direction away from the memory cell array region MCA.

A side surface of the third line portion LPb' may be coplanar with side surfaces of the third connection portion CPb', the third pad portion PPb', and the third extension portion EPb' on the side opposing the fourth bitline BL4' (in the second direction D2). In some embodiments, the side surface of the third line portion LPb' may be aligned with side surfaces of the third connection portion CPb', the third pad portion PPb', and the third extension portion EPb' in the second direction D2 on the side opposing the fourth bitline BL4' (in the second direction D2).

The third connection portion CPb' may extend in a curved shape from the third line portion LPb' to the third pad portion PPb' on the side facing the fourth bitline BL4' such that the width in the second direction D2 increases.

The third extension portion EPb' may extend in a curved shape from the third pad portion PPb' in the third direction D3 on the side facing the fourth bitline BL4' such that the width in the second direction D2 decreases.

The side surface of the fourth line portion LPd' may be coplanar with the side surfaces of the fourth connection portion CPd', the fourth pad portion PPd', and the fourth extension portion EPd' on the side opposing the third bitline BL3' (in the second direction D2). In some embodiments, the side surface of the fourth line portion LPd' may be aligned with the side surfaces of the fourth connection portion CPd', the fourth pad portion PPd', and the fourth extension portion EPd' in the second direction D2 on the side opposing the third bitline BL3' (in the second direction D2). From a similar perspective as described above, the characteristics of the fourth connection portion CPd' and the fourth extension portion EPd' may be described.

Bitlines BL' of the semiconductor device 1e may include at least one bitline group. First, second, third, and fourth bitlines BL1', BL2', BL3', and BL4', adjacent to each other in the second direction D2, may form the at least one bitline group (e.g., BG1'). For example, the first bitline group BG1' may include the first and second bitlines BL1', BL2', adjacent to each other with respect to the third bitline BL3', the third bitline BL3', and the fourth bitline BL4' on the opposite side of the third bitline BL3' with respect to the second bitline BL2'.

The at least one bitline group may include a plurality of bitline groups (e.g., BG1' and BG2'), each arranged in the second direction D2. The bitline group adjacent to the first bitline group BG1' in the second direction D2 may be referred to as the second bitline group BG2'. Each of the plurality of bitline groups (e.g., BG1' and BG2') may be arranged repeatedly in the second direction D2 as a basic unit of bitlines BL'.

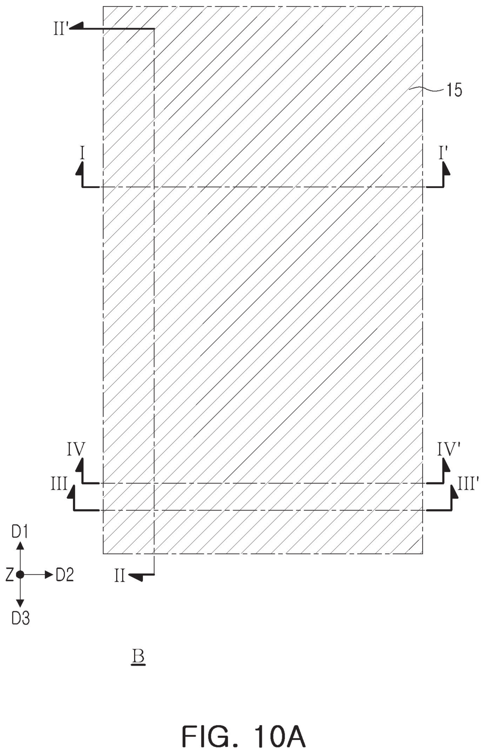

FIGS. 10A, 10B, 12A, 12B, 14A, 14B, 16A, 16B, 18A and 18B are plan diagrams illustrating a method of manufacturing a semiconductor device according to an example.

FIG. 10A, FIG. 12A, FIG. 14A, FIG. 16A, and FIG. 18A may be plan diagrams corresponding to FIG. 3A.

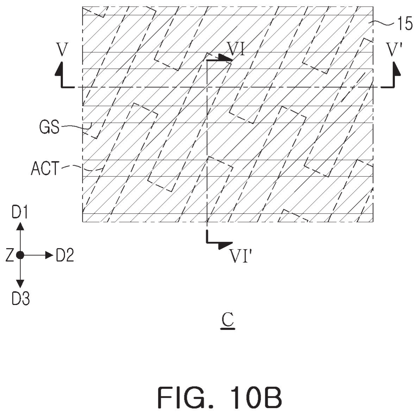

FIG. 10B, FIG. 12B, FIG. 14B, FIG. 16B, and FIG. 18B may be plan diagrams corresponding to FIG. 3B.

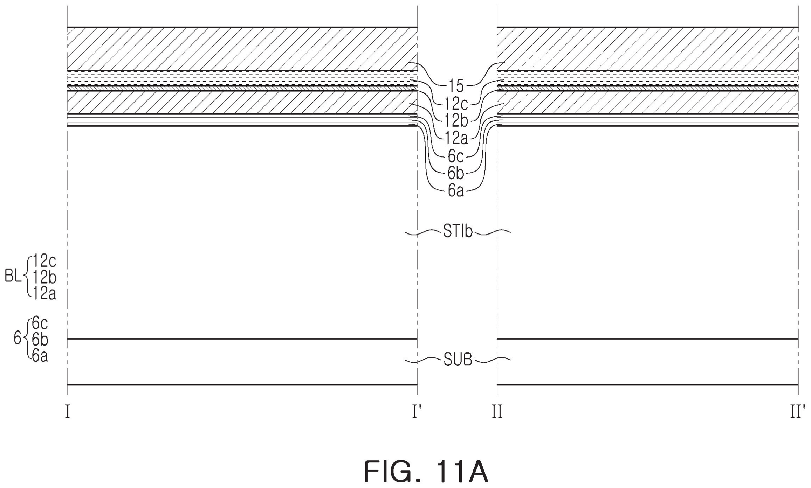

FIGS. 11A, 11B, 11C, 11D, and 11E, FIGS. 13A, 13B, 13C, 13D, and 13E, FIGS. 15A, 15B, 15C, 15D, and 15E, FIGS. 17A, 17B, 17C, 17D, and 17E, and FIGS. 19A, 19B, 19C, 19D, and 19E are cross-sectional diagrams illustrating an example of a method of manufacturing a semiconductor device according to an example embodiment.

FIG. 11A, FIG. 13A, FIG. 15A, FIG. 17A, and FIG. 19A may be cross-sectional diagrams corresponding to FIG. 4A.

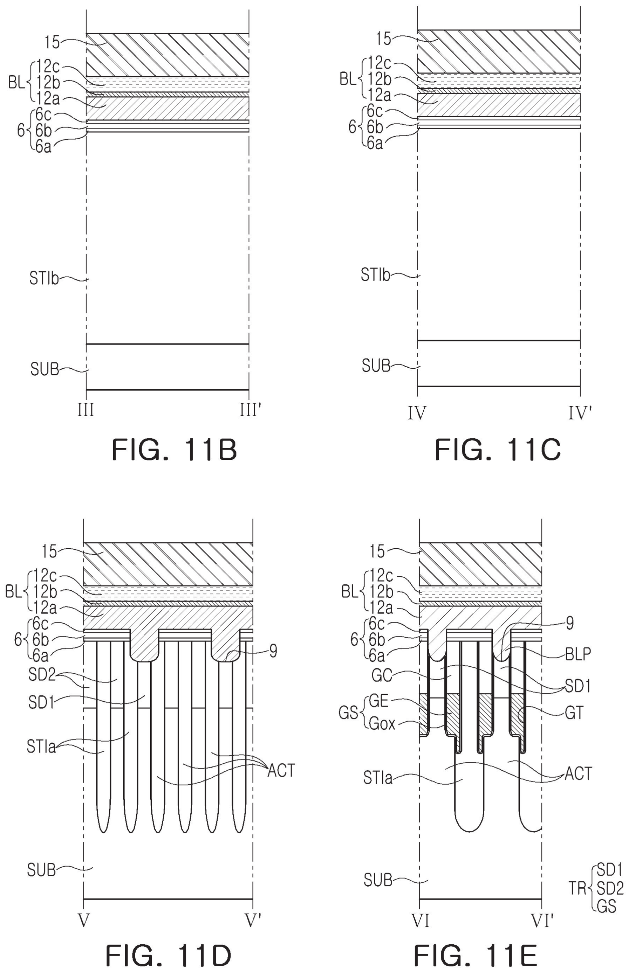

FIG. 11B, FIG. 13B, FIG. 15B, FIG. 17B, and FIG. 19B may be cross-sectional diagrams corresponding to FIG. 4B.

FIG. 11C, FIG. 13C, FIG. 15C, FIG. 17C, and FIG. 19C may be cross-sectional diagrams corresponding to FIG. 4C.

FIG. 11D, FIG. 13D, FIG. 15D, FIG. 17D, and FIG. 19D may be cross-sectional diagrams corresponding to FIG. 4D.

FIG. 11E, FIG. 13E, FIG. 15E, FIG. 17E, and FIG. 19E may be cross-sectional diagrams corresponding to FIG. 4E.

FIGS. 10A and 10B are plan diagrams illustrating an example of a method of manufacturing a semiconductor device according to an example embodiment.

FIGS. 11A, 11B, and 11C are cross-sectional diagrams illustrating the semiconductor device illustrated in FIG. 10A taken along lines I-I', II-II', III-III', and IV-IV'.

FIGS. 11D and 11E are cross-sectional diagrams illustrating the semiconductor device illustrated in FIG. 10B taken along lines V-V' and VI-VI'.

Referring to FIGS. 1, 2, 3A, 3B, 4A, 4B, 4C, 4D, and 4E, and FIGS. 10A, 10B, 11A, 11B, 11C, 11D, and 11E, a cell transistor TR may be formed. The forming the cell transistor TR may include forming active regions ACT and device isolation regions STla and STlb on a substrate SUB, forming gate trenches GT intersecting (crossing) the cell device isolation region STla among the device isolation regions STla and STIb and the active regions ACT, and forming gate patterns GS and GC within the gate trenches GT.

The forming the cell transistor TR may further include forming first and second source/drain regions SD1 and SD2 within the active regions ACT.

Each of the gate patterns GS and GC may include a gate structure GS and a gate capping layer GC on the gate structure GS. Each of the gate structures GS may include a gate dielectric layer Gox and a gate electrode GE. In each of the gate structures GS, the gate dielectric layer Gox may be formed on an inner wall of the gate trench GT, and the gate electrode GE may partially fill the gate trench GT on the gate dielectric layer Gox. The gate capping layer GC may fill at least a portion (e.g., the other portion) of the gate trench GT on the gate electrode GE. The gate capping layer GC may include (e.g., may be formed of) an insulating material.

The cell transistor TR may include the gate electrode GE, the gate dielectric layer Gox, and the first and second source/drain regions SD1 and SD2.

The device isolation regions STIa and STIb may include a cell device isolation region STIa within the memory cell array region MCA, and a peripheral device isolation region STIb within the first and second extension regions EXTa and EXTb. The device isolation regions STIa and STIb may include (e.g., may be formed of) an insulating material. The device isolation regions STIa and STIb may be shallow trench isolations.

The memory cell array region MCA may be disposed between the first extension region EXTa and the second extension region EXTb.

A buffer insulating structure 6 having openings 9 may be formed. The buffer insulating structure 6 may be on (e.g., may cover or overlap) the cell active regions ACT, the device isolation regions STla and STIb, and the gate patterns GS and GC, and the openings 9 may expose the first source/drain regions SD1.

The buffer insulating structure 6 may include a first insulating layer 6a, a second insulating layer 6b, and a third insulating layer 6c, stacked in order. The first and third insulating layers 6a and 6c may include (e.g., may be formed of), for example, silicon oxide, and the second insulating layer 6b may include (e.g., may be formed of), for example, silicon nitride.

The conductive material layers 12a, 12b, and 12c and the (first) insulating material layer 15 may be formed on the buffer insulating structure 6.

The forming the conductive material layers 12a, 12b, and 12c and the (first) insulating material layer 15 may include forming a plate pattern connected to the first source/drain regions SD1 exposed by the openings 9, and having an end portion formed on the peripheral device isolation region STIb.

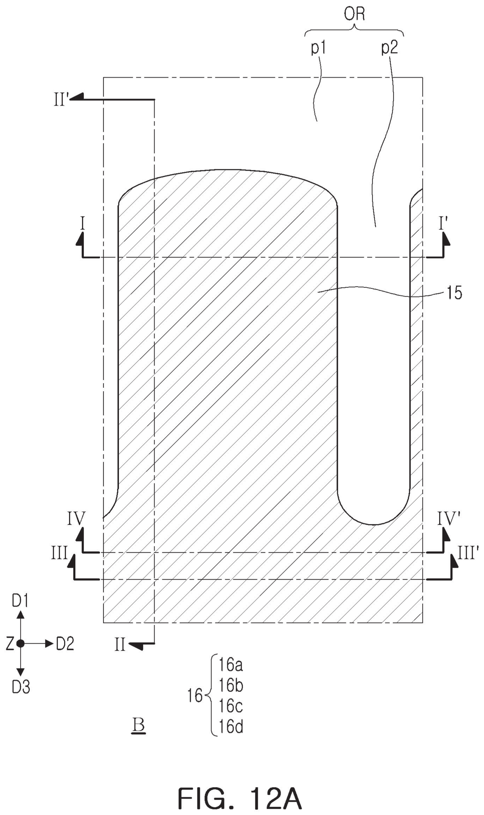

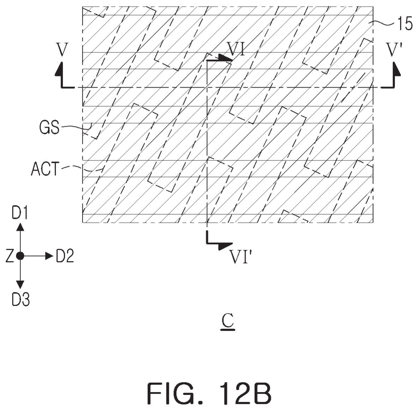

FIGS. 12A and 12B are plan diagrams illustrating an example of a method of manufacturing a semiconductor device according to an example embodiment.

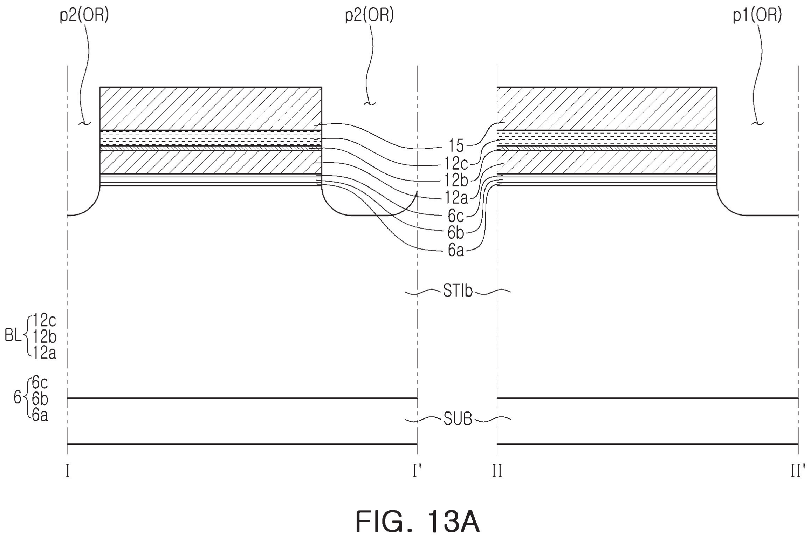

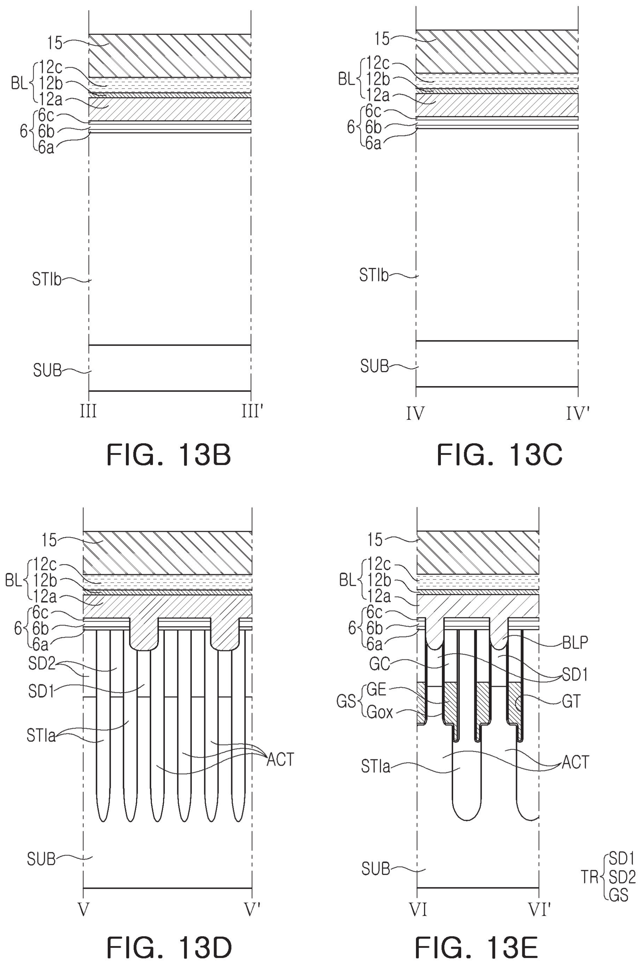

FIGS. 13A, 13B, and 13C are cross-sectional diagrams illustrating the semiconductor device illustrated in FIG. 12A taken along lines I-I', II-II', III-III', and IV-IV'.

FIGS. 13D and 13E are cross-sectional diagrams illustrating the semiconductor device illustrated in FIG. 12B taken along lines V-V' and VI-VI'.

Referring to FIG. 12A, FIG. 12B, and FIGS. 13A, 13B, 13C, 13D, and 13E, along with FIG. 1, FIG. 2, FIG. 3A, FIG. 3B, and FIGS. 4A, 4B, 4C, 4D, and 4E, the patterning process for the conductive material layers 12a, 12b, and 12c may be performed using the (first) insulating material layer 15.

The performing the patterning process for the conductive material layers 12a, 12b, and 12c may include forming an open region OR including a first portion p1 extending in the second direction D2 within the first and second extension regions EXTa and EXTb and a second portion p2 recessing the conductive material layers 12a, 12b, and 12c in a direction toward the memory cell array region MCA.

The open region OR may extend downwardly through the buffer insulating structure 6 and may extend into (e.g., at least partially penetrate) a perimeter of the peripheral device isolation region STIb.

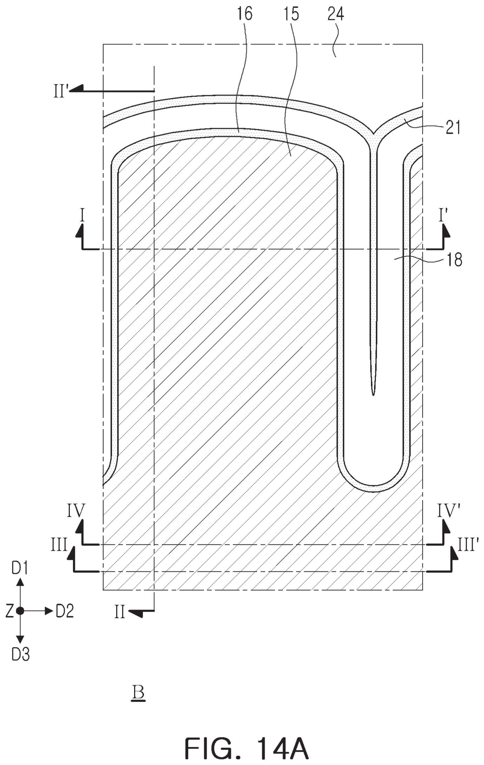

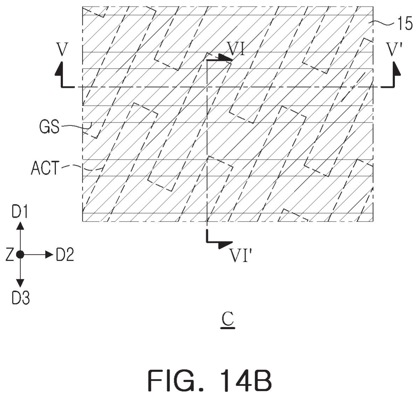

FIGS. 14A and 14B are plan diagrams illustrating an example of a method of manufacturing a semiconductor device according to an example embodiment.

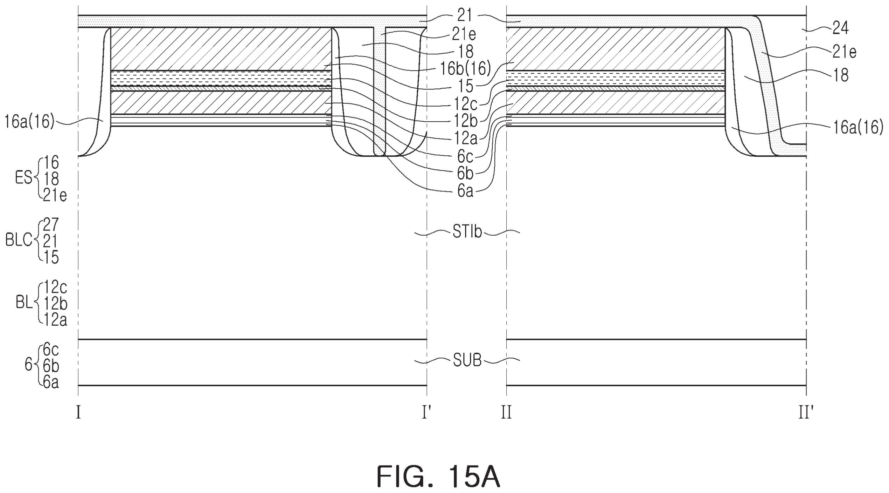

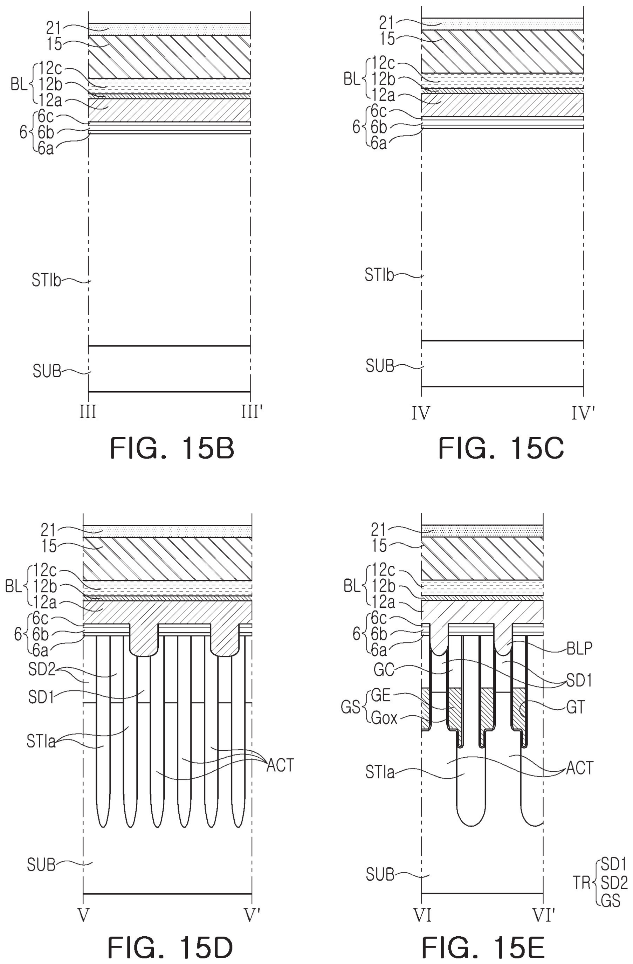

FIGS. 15A, 15B, and 15C are cross-sectional diagrams illustrating the semiconductor device illustrated in FIG. 14A taken along lines I-I', II-II', III-III', and IV-IV'.

FIGS. 15D and 15E are cross-sectional diagrams illustrating the semiconductor device illustrated in FIG. 14B taken along lines V-V' and VI-VI'.

Referring to FIGS. 1, 2, 3A, 3B, 4A, 4B, 4C, 4D, and 4E, and FIGS. 14A, 14B, 15A, 15B, 15C, 15D, and 15E, an insulating pattern ES may be formed within an open region OR. Thereafter, a lower interlayer insulating layer 24 may be formed.

The forming the insulating pattern ES may include forming a first insulating pattern 16, a second insulating pattern 18, and a third insulating pattern 21e (or 'insulating material layer 12') in order.

The forming the first insulating pattern 16 may include forming the first insulating material layer on an upper surface of the (first) insulating material layer 15 and an inner surface of the open region OR, and removing a portion of the first insulating material layer. Accordingly, the first insulating pattern 16 may remain on each of side surfaces of the (first) insulating material layer 15, the conductive material layers 12a, 12b, and 12c, and the buffer insulating structure 6. The first insulating material layer may include, for example, silicon nitride.

The forming the second insulating pattern 18 may include forming the second insulating material layer on the upper surface of the (first) insulating material layer 15 and the side surface of the first insulating pattern 16, and removing a portion of the second insulating material layer. Accordingly, the second insulating pattern 18 may remain on the side surface of the first insulating pattern 16. The second insulating material layer may include, for example, silicon oxide.

The forming the third insulating pattern 21e may include forming the third insulating material layer on the (first) insulating material layer 15 and the second insulating pattern 18. Accordingly, the second insulating material layer 21 extending in the horizontal direction D1, D2, and D3 may be formed, and the third insulating pattern 21e extending downwardly from the second insulating material layer 21 to the second insulating patterns 18 (e.g., to the peripheral device isolation region STIb) may be formed.

Thereafter, a lower interlayer insulating layer 24 may be formed on the third insulating pattern 21e within the open region OR. The lower interlayer insulating layer 24 may include, for example, silicon oxide and/or a low-κ dielectric. By forming the lower interlayer insulating layer 24, the open region OR may be buried (filled).

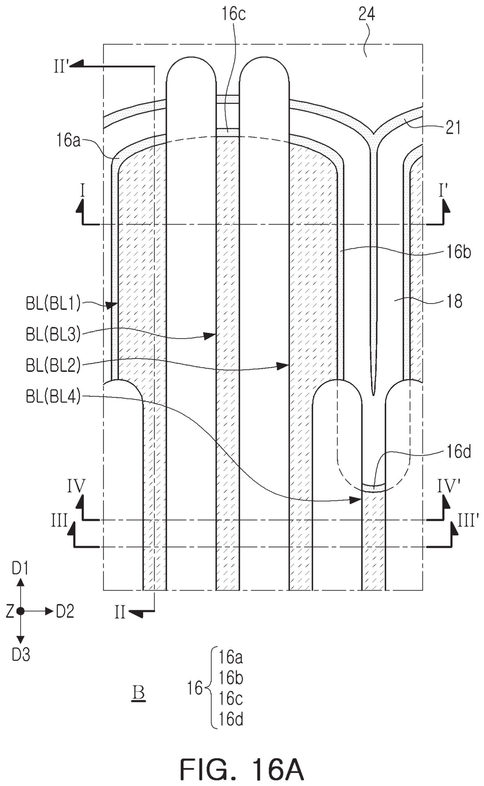

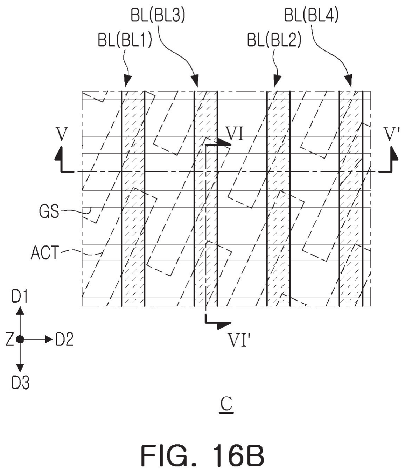

FIGS. 16A and 16B are plan diagrams illustrating an example of a method of manufacturing a semiconductor device according to an example embodiment.

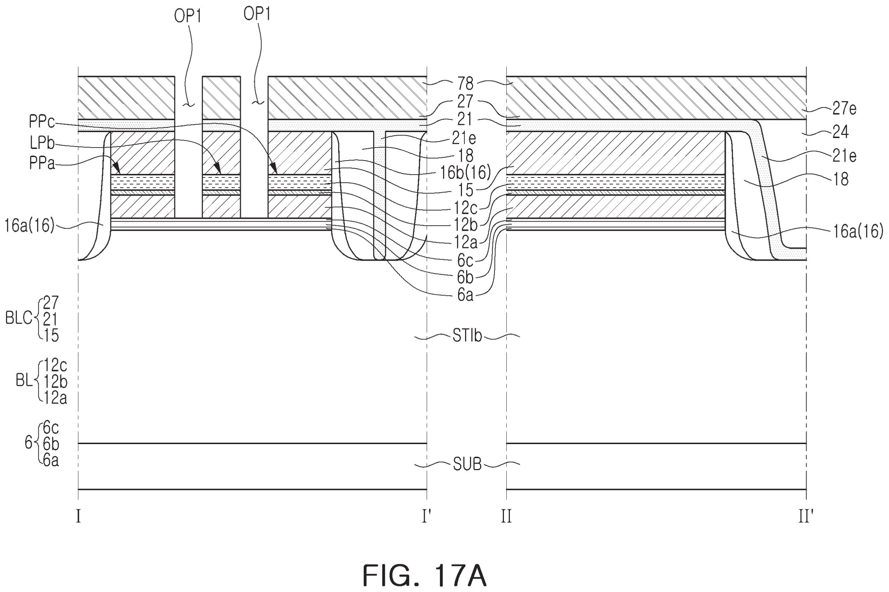

FIGS. 17A. 17B, and 17C are cross-sectional diagrams illustrating the semiconductor device illustrated in FIG. 16A taken along lines I-I', II-II', III-III' and IV-IV'.

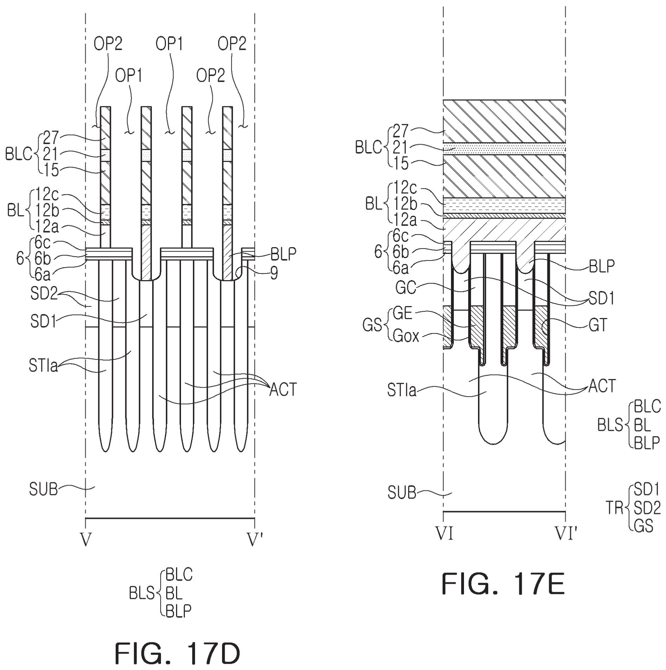

FIGS. 17D and 17E are cross-sectional diagrams illustrating the semiconductor device illustrated in FIG. 16B taken along lines V-V' and VI-VI'.

Referring to FIGS. 1, 2, 3A, 3B, 4A, 4B, 4C, 4D, and 4E, and FIGS. 16A, 16B, 17A, 17B, 17C, 17D, and 17E, a third insulating material layer 27 may be formed on a second insulating material layer 21 and a bitline capping pattern BLc may be formed. Thereafter, a plurality of open portions OP extending in the first and third directions D1 and D3 and extending into (e.g., penetrating) the bitline capping pattern BLc and the conductive material layers 12a, 12b, and 12c may be formed. By the plurality of open portions OP, first to fourth bitlines BL1, BL2, BL3, and BL4 spaced apart from each other in the second direction D2 may be defined.

A third insulating material layer 27 may be formed on the second insulating material layer 21. Accordingly, a bitline capping pattern BLc including the first, second, and third insulating material layers 15, 21, and 27 may be defined on the conductive material layers 12a, 12b, and 12c.

A plurality of open portions OP extending in first and third directions D1 and D3 and spaced apart from each other in the second direction D2 may be formed. By the plurality of open portions OP, a plurality of the bitline capping pattern BLc and a plurality of the conductive material layers 12a, 12b, and 12c may be isolated from each other and spaced apart from each other in the second direction D2. Accordingly, the first, second, third, and fourth bitlines BL1, BL2, BL3, and BL4 spaced apart from each other in the second direction D2 may be defined. Also, bitline plugs BLP connecting the bitlines BL to the first source/drain regions SD1 may be formed. The plurality of open portions OP may extend into (e.g., penetrate) the bitline capping pattern BLc and the conductive material layers 12a, 12b, and 12c, such that a portion of the upper surface of the buffer insulating structure 6 may be exposed.

The bitlines BL, the bitline plugs BLP, and the bitline capping patterns BLc may form bitline structures BLS.

The plurality of open portions OP may include first and second open portions OP1 and OP2 having different lengths in the length directions (e.g., the first direction D1 and the third direction D3). For example, the first length of the first open portions OP1 may be longer than the second length of the second open portions OP2 in the length direction.

The first open portions OP1 may be formed to overlap the first portion p1 of the open region OR. In the first open portions OP1, at least a portion of the insulating pattern ES may penetrate a portion extending the second direction D2 in a direction away from the memory cell array region MCA, and may extend into a portion of the lower interlayer insulating layer 24. Accordingly, a 4n+2nd bitline BLb (or a third bitline BL3) of the bitlines BL may be defined.

The second open portions OP2 may be formed to overlap the second portion p2 of the open region OR. In the second open portions OP2, at least a portion of the insulating pattern ES may extend in the direction away from the memory cell array region MCA within the portion extending in the third direction D3. Accordingly, among bitlines BL, a 4n+1st bitline BLa (or first bitline BL1), a 4n+3rd bitline BLc (or second bitline BL2), and a 4n+4th bitline BLd (or fourth bitline BL4) may be defined.

FIGS. 11A, 11B, 11C, 11D, and 11E, 13A, 13B, 13C, 13D, and 13E, 15A, 15B, 15C, 15D, and 15E, 17A, 17B, 17C, 17D, and 17E, and 19A, 19B, 19C, 19D, and 19E are cross-sectional diagrams illustrating a method of manufacturing a semiconductor device according to an example.

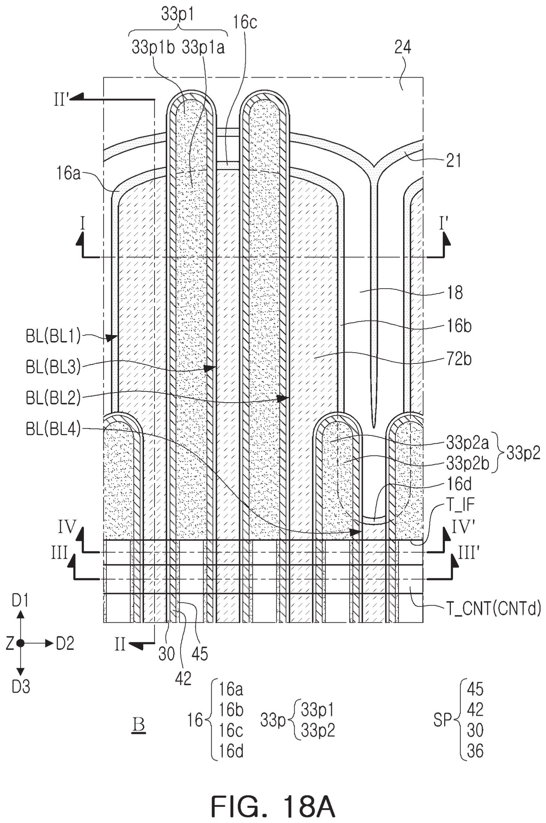

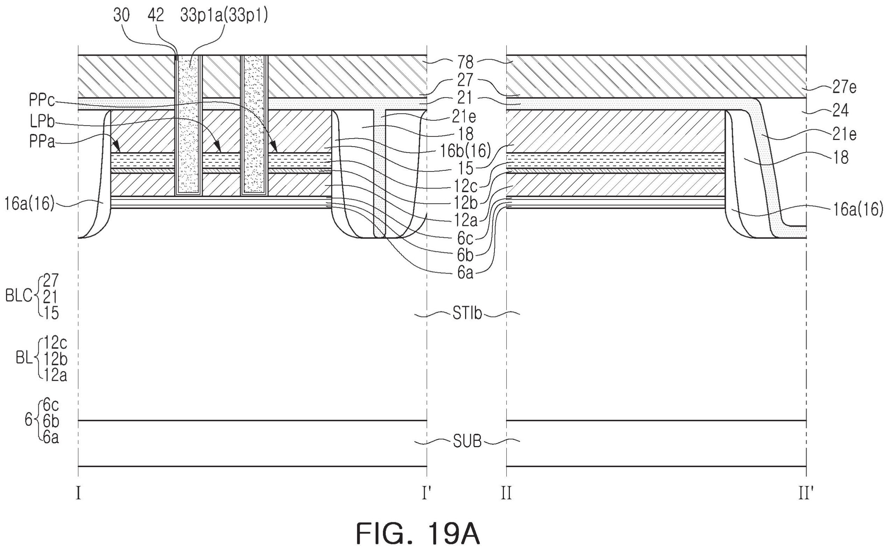

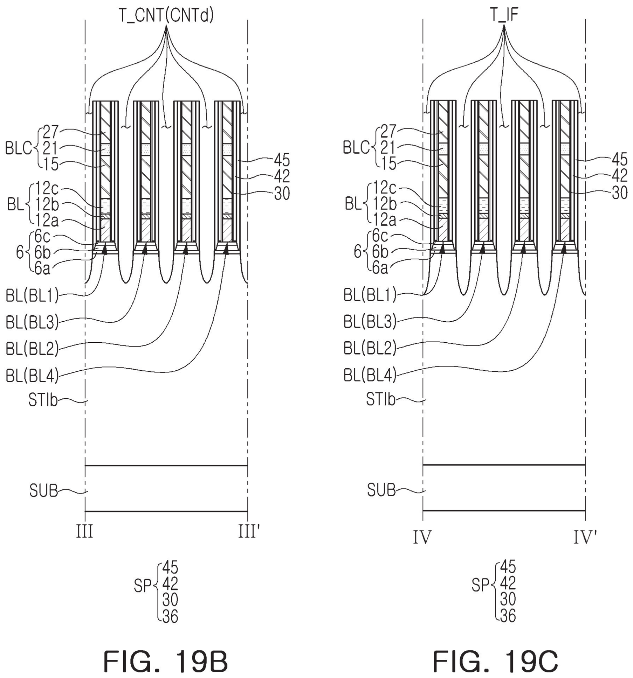

FIGS. 19A, 19B, and 19C are cross-sectional diagrams illustrating the semiconductor device illustrated in FIG. 18A taken along lines I-I', II-II', III-III', and IV-IV'.

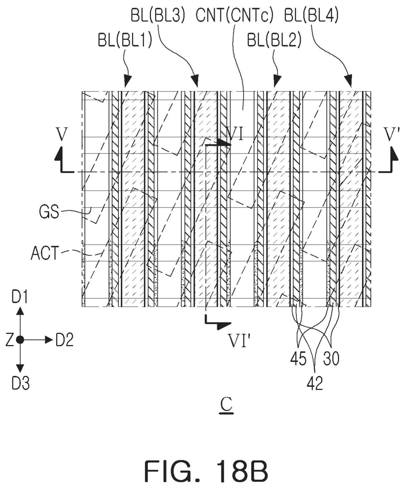

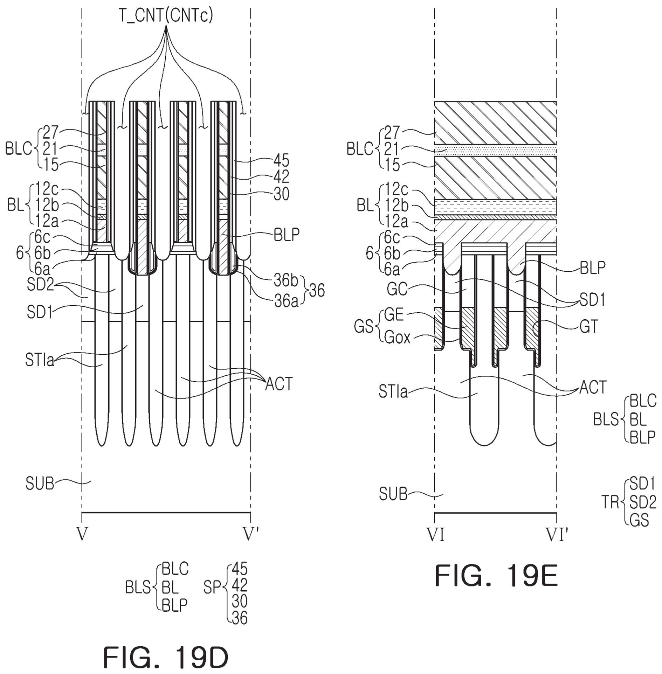

FIGS. 19D and 19E are cross-sectional diagrams illustrating the semiconductor device illustrated in FIG. 18B taken along lines V-V' and VI-VI'.

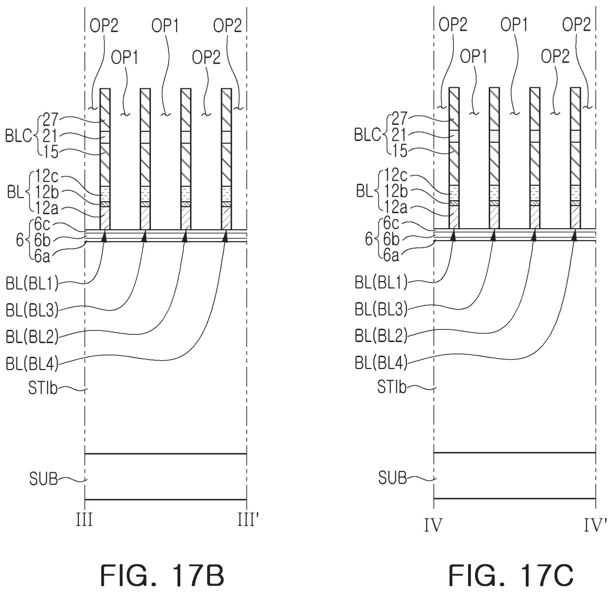

Referring to FIGS. 18A, 18B, 19A, 19B, 19C, 19D, and 19E, along with FIGS. 1, 2, 3A, 3B, 4A, 4B, 4C, 4D, and 4E, plug spacer 36 may be formed. Thereafter, an inner spacer 30, an intermediate spacer 42, and an insulating structure 33p may be formed within the plurality of open portions OP described with reference to FIGS. 16A, 16B, 17A, 17B, 17C, 17D, and 17E. Thereafter, a first trench T_IF for forming an insulating fence IF and second trenches T_CNT for forming contact plugs CNT may be formed.

A plug spacer 36 may be formed. The plug spacer 36 may be formed on a side surface of the bitline plug BLc within the opening 9. The plug spacer 36 may include a spacer pattern 36b and a spacer liner 36a covering a side surface and a lower surface of the spacer pattern 36b.

Referring to FIGS. 16A, 16B, 17A, 17B, 17C, 17D, and 17E, a plurality of insulating material layers may be formed in order within the plurality of open portions OP, and an inner spacer 30, an intermediate spacer 42, and an insulating structure 33p may be formed.

A first trench T_IF intersecting (crossing) the line portion LP of the bitlines BL in the second direction D2 and spaced apart from in the first and third directions D1 and D3 may be formed. The first trench T_IF may be provided to form an insulating fence IF.

A plurality of second trenches T_CNT spaced apart from each other may be provided between the first trenches T_IF. The plurality of second trenches T_CNT may be provided to form contact plugs CNT. The second trenches T_CNT may include, for example, a first trench portion T_CNT CNTd for forming a dummy contact plug CNTd and a second trench portion T_CNT CNTc for forming a cell contact plug CNTc.

An outer spacer 45 may be defined by the plurality of second trenches T_CNT. The outer spacer 45 may be formed on side surfaces of the bitlines BL, the bitline capping patterns BLc, and the insulating structure 33p.

A plurality of conductive patterns CNT may be formed within the second trenches T_CNT. The conductive patterns CNT may be the contact plugs described above. The conductive patterns CNT may be spaced apart from the insulating fences IF.

Referring to FIGS. 1, 2, 3A, 3B, 4A, 4B, 4C, 4D, and 4E, the insulating fences IF may be formed to partially penetrate the bitline capping patterns BLc and may extend to a region between the bitlines BL.

The forming the conductive patterns, that is, the contact plugs CNT, may include forming a first material layer filling a region between the line portions LP, forming the insulating fences IF, isolating the first material layers from each other in the first direction D1, etching a portion of the isolated first material layer and forming a lower conductive layer 55, forming an upper spacer 58 on a side surface of a space of an upper portion of the lower conductive layer 55, performing a silicide process and forming an intermediate conductive layer 61 on the lower conductive layer 55, and forming an upper conductive layer 64 on the intermediate conductive layer 61.
During the forming the upper conductive layer 64, bitline contact structures 72 penetrating the bitline capping patterns BLc and electrically connected to the pad portions PP of the bitlines BL may be formed. The bitline capping patterns penetrating the BLc and the bitline contact structures 72 electrically connect the. The upper conductive layer 64 and the bitline contact structures 72 may be formed simultaneously.

Thereafter, a conductive layer may be formed, and the conductive layer may be patterned and conductive patterns 75i and 75p may be formed, an insulating isolation pattern 78 passing between the conductive patterns 75i and 75p may be formed, and an etch-stop layer 85 may be formed on the conductive patterns 75i and 75p and the insulating isolation pattern 78.

The conductive patterns 75i and 75p may include first conductive patterns 75i (electrically) connected to the bitline contact structures 72 within the first and second extension regions EXTa and EXTb and extending to the upper interlayer insulating layer 27e, and second conductive patterns 75p electrically connected to the cell contact plugs CNTc within the memory cell array region MCA.

A data storage structure DS may be formed. The data storage structure DS may be formed within the memory cell array region MCA. The data storage structure DS may include first electrodes 88 extending into (e.g., penetrating) the etch-stop layer 85 and electrically connected to the second conductive patterns 75p, a dielectric layer 90 on (e.g., covering) the first electrodes 88 and the etch-stop layer 85, and a second electrode 92 on the dielectric layer 90.

According to the aforementioned example embodiments, a semiconductor device having improved reliability and a method of manufacturing the same may be provided.

Also, a semiconductor device including an insulating pattern on a side surface of a line portion of a bitline may be provided.

Specifically, an insulating pattern may remain at the end of the line portion after patterning the bitline, such that a semiconductor device including bitlines of which degradation is reduced or prevented may be provided.

According to an example embodiment of the present disclosure, a method of manufacturing a semiconductor device includes forming a substrate, wherein the substrate includes a memory cell array region and first and second extension regions adjacent to the memory cell array region, forming bitlines extending in a first direction on the substrate and spaced apart from each other in a second direction, wherein the second direction is perpendicular to the first direction, wherein the forming the bitlines includes forming a conductive material layer on the substrate and patterning the conductive material layer, the patterning includes forming an open region including a first portion extending in the second direction within the first and second extension regions and a second portion recessing the conductive material layer in a direction toward the memory cell array region, and forming an insulating pattern filling the open region and covering the conductive material layer, forming a plurality of open portions extending in the first direction and spaced apart from each other in the second direction on the conductive material layer, and the forming the plurality of open portions includes forming first open portions having a first length and adjacent to each other in the second direction so as to overlap the first portion, and forming second open portions having a second length less than the first length and adjacent to each other in the second direction so as to overlap the second portion.

After forming the insulating pattern, forming an insulating structure on the side surface of the insulating pattern may be included.

An upper surface of the insulating structure may be (substantially) coplanar with an upper surface of the insulating pattern.

The first open portions may extend into (e.g., penetrate) a portion filling a first portion of the open region of the insulating pattern and may extend into the insulating structure.

The second open portions may extend into a portion filling the second portion of the open region of the insulating pattern.

The bitline may include at least one bitline group, and the at least one bitline group may include first to fourth bitlines defined by the plurality of open portions.

The at least one bitline group may include a plurality of first bitline groups, and the plurality of first bitline groups are arranged repeatedly in the second direction.

The first bitline includes a first line portion intersecting (crossing) the memory cell array region in a first direction from the memory cell array region toward the first extension region and extending into the first extension region, a first connection portion extending from the first line portion within the first extension region, a first pad portion extending from the first connection portion within the first extension region, and a first extension portion extending from the first pad portion within the first extension region, a second bitline including a second line portion intersecting (crossing) the memory cell array region in the first direction and extending into the first extension region, a second connection portion extending from the second line portion within the first extension region, a second pad portion extending from the second connection portion within the first extension region, and a second extension portion extending from the second pad portion within the first extension region, and the third bitline is disposed in the memory cell array region and the first extension region, and includes a third line portion having an end portion between the first extension portion and the second extension portion.

A side surface of the first line portion is aligned in the second direction with a side surface of each of the first connection portion, the first pad portion, and the first extension portion on a side facing the third bitline.

The first connection portion extends from the first line portion to the first pad portion in a curved shape, and the first extension portion extends from the first pad portion in a curved shape, on a second side which is an opposite side of the first side.

## Claims

1. A semiconductor device (1), comprising:
a substrate (SUB) that includes a memory cell array region (MCA) and a first extension region (EXTa) that is adjacent to the memory cell array region (MCA);
a first bitline (BL1) that includes a first line portion (LPa) that intersects the memory cell array region (MCA) in a first direction (D1) from the memory cell array region (MCA) toward the first extension region (EXTa) and extends into the first extension region (EXTa), a first connection portion (CPa) that extends from the first line portion (LPa) within the first extension region (EXTa), a first pad portion (PPa) that extends from the first connection portion (CPa) within the first extension region (EXTa), and a first extension portion (EPa) that extends from the first pad portion (PPa) within the first extension region (EXTa);
a second bitline (BL2) that includes a second line portion (LPc) that intersects the memory cell array region (MCA) in the first direction (D1) and extends in the first extension region (EXTa), a second connection portion (CPc) that extends from the second line portion (LPc) within the first extension region (EXTa), a second pad portion (PPc) that extends from the second connection portion (CPc) within the first extension region (EXTa), and a second extension portion (EPc) that extends from the second pad portion (PPc) within the first extension region (EXTa); and
a third bitline (BL3) in the memory cell array region (MCA) and the first extension region (EXTa), wherein the third bitline (BL3) includes a third line portion (LPb) that has an end portion between the first extension portion (EPa) and the second extension portion (EPc) in a second direction (D2) that is perpendicular to the first direction (D1),
wherein a width in the second direction (D2) of the first extension portion (EPa) decreases from the first pad portion (PPa) in the first direction (D1),
wherein a width in the second direction (D2) of the second extension portion (EPc) decreases from the second pad portion (PPc) in the first direction (D1), and
wherein the end portion of the third line portion (LPb) of the third bitline (BL3) has a convex shape in the first direction (D1).

2. The semiconductor device (1) of claim 1, wherein a side surface of the first line portion (LPa) is coplanar with a side surface of each of the first connection portion (CPa), the first pad portion (PPa), and the first extension portion (EPa) on a first side that faces the third bitline (BL3).

3. The semiconductor device (1) of claim 2, wherein the first connection portion extends from the first line portion (LPa) to the first pad portion (PPa) in a first curved shape, and the first extension portion (EPa) extends from the first pad portion (PPa) in a second curved shape, on a second side that is opposite to the first side in the second direction (D2).

4. The semiconductor device (1) of any one of claims 1 to 3, wherein a side surface of the second line portion (LPc) is coplanar with a side surface of each of the second connection portion (CPc), the second pad portion (PPc), and the second extension portion (EPc) on a third side that faces the third bitline (BL3).

5. The semiconductor device (1) of claim 4, wherein the second connection portion extends in a third curved shape from the second line portion (LPc) to the second pad portion (PPc), and the second extension portion (EPc) extends in a fourth curved shape from the second pad portion (PPc) on a fourth side that is opposite to the third side in the second direction (D2).

6. The semiconductor device (1) of any one of the previous claims, further comprising:
an insulating pattern that includes a first insulating pattern (16),
wherein the first insulating pattern (16) includes:
a first portion (16a) on side surfaces of the first pad portion (PPa) and the first extension portion (EPa) of the first bitline (BL1);
a second portion (16b) on a side surface of the second pad portion (PPc) and the second extension portion (EPc) of the second bitline (BL2); and
a third portion (16c) on the end portion of the third line portion (LPb) of the third bitline (BL3).

7. The semiconductor device (1) of claim 6,
wherein the insulating pattern further includes:
a second insulating pattern (18) on a side surface of the first insulating pattern (16); and
a third insulating pattern (21e) on the second insulating pattern (18).

8. The semiconductor device (1) of any one of the previous claims, wherein a width in the second direction (D2) of the end portion of the third line portion (LPb) of the third bitline (BL3) increases in the first direction (D1).

9. The semiconductor device (1) of any one of the previous claims, further comprising:
a first insulating structure (33p1),
wherein the first insulating structure (33p1) includes a first insulating portion (33p1a) between the first bitline (BL1) and the third bitline (BL3) and between the second bitline (BL2) and the third bitline (BL3).

10. The semiconductor device (1) of claim 9, wherein the first insulating structure (33p1) further includes an extension insulating portion (33p1b ) extending from the first insulating portion (33p1a) in a direction away from the memory cell array region (MCA).

11. The semiconductor device (1) of any one of the previous claims, further comprising:
a first bitline contact plug (72a) that is on the first pad portion (PPa) and electrically connected to the first pad portion (PPa); and
a second bitline contact plug (72b) that is on the second pad portion (PPc) and electrically connected to the second pad portion (PPc),
wherein:
a central portion of the first bitline contact plug (72a) is aligned with a central portion of the first pad portion (PPa) in the first direction (D1), and a central portion of the second bitline contact plug (72b) is aligned with a central portion of the second pad portion (PPc) in the first direction (D1).

12. The semiconductor device (1) of claim 11, wherein the first and second bitline contact plugs (72a, 72b) are misaligned in the second direction (D2).

13. The semiconductor device (1) of claim 11 or 12, further comprising:
an insulating pattern (ES) on side surfaces of the first pad portion (PPa) and the first extension portion (EPa) of the first bitline (BL1) and side surfaces of the second pad portion (PPc) and the second extension portion (EPc) of the second bitline (BL2),
wherein at least one of the first and second bitline contact plugs (72a, 72b) is in contact with at least a portion of the insulating pattern (ES).

14. The semiconductor device of claim 1, further comprising:
a first bitline contact plug (72a) that is on the first pad portion (PPa) and electrically connected to the first pad portion (PPa); and
a second bitline contact plug (72b) that is on the second pad portion (PPc) and electrically connected to the second pad portion (PPc),
wherein a central portion of the first bitline contact plug (72a) is aligned with a central portion of the first line portion (LPa) in the first direction (D1), and a central portion of the second bitline contact plug (72b) is aligned with a central portion of the second line portion (LPc) in the first direction (D1).
